(19) Europäisches Patentamt
European Patent Office
Office européen des brevets

(11) EP 3 835 339 A1

(12) EUROPEAN PATENT APPLICATION
published in accordance with Art. 153(4) EPC

(43) Date of publication:
**16.06.2021 Bulletin 2021/24**

(21) Application number: **19846178.2**

(22) Date of filing: **06.08.2019**

(51) Int Cl.:
***C08G 81/00*** *(2006.01)* ***C08L 63/00*** *(2006.01)*

(86) International application number:
**PCT/JP2019/030875**

(87) International publication number:
**WO 2020/032015 (13.02.2020 Gazette 2020/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **10.08.2018 JP 2018151726**

(71) Applicant: **Toray Industries, Inc.**
**Tokyo, 103-8666 (JP)**

(72) Inventors:
- **ISAGO, Yuka**
  **Nagoya-shi, Aichi 455-8502 (JP)**
- **MIYAURA, Kenshi**
  **Iyo-gun, Ehime 791-3193 (JP)**
- **ASANO, Itaru**
  **Nagoya-shi, Aichi 455-8502 (JP)**

(74) Representative: **Kador & Partner PartG mbB**
**Corneliusstraße 15**
**80469 München (DE)**

# (54) POLYSILOXANE-POLYALKYLENE GLYCOL BLOCK COPOLYMER AND METHOD FOR PRODUCING SAME

(57) A polysiloxane-polyalkylene glycol block copolymer obtained by reacting a polysiloxane (A) having a functional group selected from a carboxylic anhydride group, a hydroxyl group, an epoxy group, an amino group, and a thiol group with a polyalkylene glycol (B) having a functional group selected from a carboxylic anhydride group, a hydroxyl group, an amino group, an epoxy group, and a thiol group to obtain a polysiloxane-polyalkylene glycol block copolymer intermediate, and further reacting a part of the carboxyl groups of the polysiloxane-polyalkylene glycol block copolymer intermediate with a compound reactive with a carboxyl group, wherein a content of a structure derived from the polysiloxane (A) is 30% by mass or more and 70% by mass or less with respect to 100% by mass of the entire polysiloxane-polyalkylene glycol block copolymer, and wherein the polysiloxane-polyalkylene glycol block copolymer has a carboxyl group content of 0.1 mmol/g to 0.75 mmol/g and a weight average molecular weight of 5,000 to 500,000. Provided is a polysiloxane-polyalkylene glycol block copolymer which is well dispersed in an epoxy resin in the case of being blended with the epoxy resin, and can achieve a decreased stress of the cured epoxy resin.



Printed by Jouve, 75001 PARIS (FR)

## Description

### TECHNICAL FIELD

The present invention relates to: a polysiloxane-polyalkylene glycol block copolymer suitably used for a cured epoxy resin such as a semiconductor encapsulating material; and a method for producing the same.

### BACKGROUND ART

In recent years, electronic equipment has been more and more miniaturized. This has been accompanied by thinning semiconductor packages, creating a problem in that a stress smaller than conventional one is more likely to cause cracking on such packages. In addition, a demand for power semiconductors is expected to increase in the future. A power semiconductor has a high heating value, and thus, the environment of usage creates high temperature, and causes the chip and the encapsulating material, which have a difference in the thermal expansion coefficient therebetween, to be peeled off at the interface, making it more likely that the package is damaged. These facts require a semiconductor encapsulating material to cause a further decreased stress.

Semiconductor encapsulating materials are generally composed of an epoxy resin, a curing agent, a filler, and various additives such as a stress relief agent and a flame retardant. One method for decreasing a stress of a semiconductor encapsulating material is to decrease the modulus of elasticity of a cured epoxy resin, in which method it is general that a compound containing a polysiloxane as a main component is added as a stress relief agent to the resin. However, a polysiloxane has poor dispersibility in a cured epoxy resin, and accordingly, a known technology uses an ABA type triblock copolymer in which both ends of a polysiloxane are modified with polyalkylene glycol chains (Patent Document 1). In addition, as a technique for further improving the dispersibility in a cured epoxy resin, a method in which a glycidyl group or a carboxyl group is introduced into the ends of a multiblock copolymer composed of a polysiloxane and a polyalkylene glycol is disclosed (Patent Document 2).

### PRIOR ART DOCUMENTS

### PATENT DOCUMENTS

Patent Document 1: Japanese Patent Laid-open Publication No. 10-182831
Patent Document 2: Japanese Patent Laid-open Publication No. 4-359023

### SUMMARY OF THE INVENTION

### PROBLEMS TO BE SOLVED BY THE INVENTION

The properties of stress relief agents added in semiconductor encapsulating materials are required to have an effect of lowering the modulus of elasticity of semiconductor encapsulating material as well as further additional values, such as improvement of fluidity and good dispersion in the matrix resin.

On the other hand, the ABA type triblock copolymer composed of polysiloxane middle block modified with polyalkylene glycol end-blocks and the copolymer composed of a polysiloxane and a polyalkylene glycol and having a glycidyl group or a carboxyl group introduced into both ends of the copolymer have problems such as an insufficient effect of improving the dispersibility and coarse dispersion in the cured epoxy resin.

An object of the present invention is to provide a polysiloxane-polyalkylene glycol block copolymer which has excellent dispersibility in a cured epoxy resin and achieves a decreased stress of the cured epoxy resin to be obtained.

### SOLUTIONS TO THE PROBLEMS

In order to solve the above-mentioned problems, the present inventors have conducted intensive investigations and, as a result, have completed the following invention. That is, the present invention is as follows:

<1> a polysiloxane-polyalkylene glycol block copolymer obtained by
reacting a polysiloxane (A) having a functional group selected from a carboxylic anhydride group, a hydroxyl group, an epoxy group, an amino group, and a thiol group with a polyalkylene glycol (B) having a functional group selected from a carboxylic anhydride group, a hydroxyl group, an amino group, an epoxy group, and a thiol group to obtain

a polysiloxane-polyalkylene glycol block copolymer intermediate, and
further reacting a part of the carboxyl groups of the polysiloxane-polyalkylene glycol block copolymer intermediate with a compound reactive with a carboxyl group,
wherein a content of a structure derived from the polysiloxane (A) is 30% by mass or more and 70% by mass or less with respect to 100% by mass of the entire polysiloxane-polyalkylene glycol block copolymer, and
wherein the polysiloxane-polyalkylene glycol block copolymer has a carboxyl group content of 0.1 mmol/g to 0.75 mmol/g and a weight average molecular weight of 5,000 to 500,000;
<2> a method for producing a polysiloxane-polyalkylene glycol block copolymer, the method comprising the following step (1) followed by the following step (2):

the step (1): reacting a polysiloxane (A) having a functional group selected from a carboxylic anhydride group, a hydroxyl group, an epoxy group, an amino group, and a thiol group with a polyalkylene glycol (B) having a functional group selected from a carboxylic anhydride group, a hydroxyl group, an amino group, an epoxy group, and a thiol group to obtain a polysiloxane-polyalkylene glycol block copolymer intermediate; and
the step (2): reacting a carboxyl group of the polysiloxane-polyalkylene glycol block copolymer intermediate obtained in the step (1) with a compound reactive with a carboxyl group,
wherein the compound reactive with a carboxyl group is at least one selected from ortho esters, oxazolines, epoxies, alcohols, monovalent phenols, alkyl halides, and alkyl carbonates;

<3> an epoxy resin composition containing the polysiloxane-polyalkylene glycol block copolymer and an epoxy resin; and
<4> a cured epoxy resin containing the epoxy resin composition being cured.

## EFFECTS OF THE INVENTION

The polysiloxane-polyalkylene glycol block copolymer of the present invention is a block copolymer having a polysiloxane which is incompatible with an epoxy resin but exhibits excellent flexibility and a polyalkylene glycol which is compatible with an epoxy resin and exhibits excellent flexibility, and the polysiloxane-polyalkylene glycol block copolymer exhibits both flexibility and good dispersibility in a cured epoxy resin. The polysiloxane-polyalkylene glycol block copolymer of the present invention is well dispersed in a cured epoxy resin in the case of being blended with the epoxy resin, and can achieve a decreased stress of the cured epoxy resin. Moreover, in a preferred aspect, a decrease in fluidity caused by the addition of the polysiloxane-polyalkylene glycol block copolymer to an epoxy resin is also suppressed. From these facts, this block copolymer is also useful as various additives such as a surfactant and a resin modifier and is particularly suitable as a stress relief agent for semiconductor encapsulating materials.

## BRIEF DESCRIPTION OF THE DRAWINGS

Fig. 1 is a cross-sectional TEM image of a cured epoxy resin obtained in Example 1.
Fig. 2 is a cross-sectional TEM image of a cured epoxy resin obtained in Example 2.

## EMBODIMENTS OF THE INVENTION

The polysiloxane-polyalkylene glycol block copolymer of the present invention is a polysiloxane-polyalkylene glycol block copolymer (hereinafter, simply referred to as a block copolymer in some cases) obtained by reacting a polysiloxane (A) having a functional group selected from a carboxylic anhydride group, a hydroxyl group, an epoxy group, an amino group, and a thiol group with a polyalkylene glycol (B) having a functional group selected from a carboxylic anhydride group, a hydroxyl group, an amino group, an epoxy group, and a thiol group to obtain a polysiloxane-polyalkylene glycol block copolymer intermediate (hereinafter, simply referred to as a block copolymer intermediate in some cases), and further reacting a part of the carboxyl groups of the polysiloxane-polyalkylene glycol block copolymer intermediate with a compound reactive with a carboxyl group, wherein a content of a structure derived from the polysiloxane (A) is 30% by mass or more and 70% by mass or less with respect to 100% by mass of the entire polysiloxane-polyalkylene glycol block copolymer, and wherein the polysiloxane-polyalkylene glycol block copolymer has a carboxyl group content of 0.1 mmol/g to 0.75 mmol/g and a weight average molecular weight of 5,000 to 500,000.
Here, as the reaction of the polysiloxane (A) having a functional group (hereinafter, simply referred to as the polysiloxane (A) in some cases) with the polyalkylene glycol (B) having a functional group (hereinafter, simply referred to as the polyalkylene glycol (B) in some cases), the polysiloxane (A) having a functional group and the polyalkylene

glycol (B) having a functional group may directly react with each other to be bonded to each other or the polysiloxane (A) having a functional group and the polyalkylene glycol (B) having a functional group may be bonded to each other via the copolymerization component (C) which reacts with both the component (A) and the component (B). Such a reaction makes it possible to obtain the polysiloxane-polyalkylene glycol block copolymer intermediate.

Incidentally, in a case in which the polysiloxane (A) having a functional group and the polyalkylene glycol (B) having a functional group are bonded to each other via the copolymerization component (C), the block copolymer intermediate can be obtained even in a case in which these do not directly react with each other.

In a case in which the polysiloxane (A) having a functional group directly reacts with the polyalkylene glycol (B) having a functional group, the functional group of one of the polysiloxane (A) and the polyalkylene glycol (B) must be a carboxylic anhydride group, and the functional group of the other must be a hydroxyl group, an epoxy group, an amino group, or a thiol group, in order that a carboxyl group can be introduced into the block copolymer intermediate to be obtained. In addition, from the viewpoint of the viscosity of the block copolymer intermediate to be obtained, it is more preferable that the functional group of one of the polysiloxane (A) and the polyalkylene glycol (B) is a carboxylic anhydride group, and that the functional group of the other is a hydroxyl group, an amino group, or a thiol group. From the viewpoint of the heat resistance of the block copolymer to be obtained, it is still more preferable that the functional group of any one of the polysiloxane (A) and the polyalkylene glycol (B) is a carboxylic anhydride group, and that the functional group of the other is a hydroxyl group or an amino group.

In a case in which the polysiloxane (A) and the polyalkylene glycol (B) are bonded to each other as the functional group of the polysiloxane (A) and the functional group of the polyalkylene glycol (B) directly react with each other, a bond selected from an ester bond, an amide bond, and a thioester bond is formed by the reaction of the functional groups of the polysiloxane (A) and polyalkylene glycol (B). Among these, an ester bond or a thioester bond is preferable from the viewpoint of viscosity, and an ester bond is more preferable from the viewpoint of heat resistance. Incidentally, the bonding site in the block copolymer intermediate to be obtained includes a carboxyl group produced by reaction.

Incidentally, a plurality of polysiloxanes (A) having different functional groups and/or a plurality of polyalkylene glycols (B) having different functional groups may be reacted with each other.

The polysiloxane-polyalkylene glycol block copolymer of the present invention has a carboxyl group content which can be regulated to a desired value by reacting a part of the carboxyl groups of the block copolymer intermediate obtained as above-mentioned with a compound reactive with a carboxyl group. This reaction causes the carboxyl group to be capped, and thus, produces a substituent containing a carboxylic acid derivative.

Specific examples of compounds reactive with a carboxyl group include esterifying agents and amidating agents. An esterifying agent refers to a compound which reacts with a carboxyl group to form an ester bond, and an amidating agent refers to a compound which reacts with a carboxyl group to form an amide bond.

Examples of esterifying agents include ortho esters, oxazolines, epoxies, alcohols, monovalent phenols, dimethylformamide dialkylacetals, alkyl halides, and alkyl carbonates.

Specific examples of ortho esters include trimethyl orthoformate, trimethyl orthoacetate, triethyl orthoformate, triethyl orthoacetate, tripropyl orthoformate, tripropyl orthoacetate, tributyl orthoformate, and tributyl orthoacetate.

Examples of oxazolines include 2-methyl-2-oxazoline, 2-ethyl-2-oxazoline, 2-phenyl-2-oxazoline, 2-propyl-2-oxazoline, 2-isopropyl-2-oxazoline, and 2,4,4-trimethyl-2-oxazoline. In a case in which an oxazoline is used as an esterifying agent, a substituent containing a carboxylic acid derivative generated after reaction is an ester group and has an amide group. In addition, oxazolines generate no byproduct in reaction with a carboxyl group, and thus, are preferable.

Epoxies refer to compounds having an epoxy group, and specific examples thereof include: monovalent epoxy compounds such as propylene oxide, isobutylene oxide, 1,2-butylene oxide, 1,2-epoxypentane, 1,2-epoxyhexane, 1,2-epoxyheptane, 1,2-epoxyoctane, 1,2-epoxydecane, 1,2-epoxydodecane, 1,2-epoxytetradecane, 1,2-epoxyhexadecane, 1,2-epoxyoctadecane, glycidylmethyl ether, ethylglycidyl ether, butylglycidyl ether, t-butylglycidyl ether, benzylglycidyl ether, phenylglycidyl ether, 4-t-butylphenylglycidyl ether, glycidyllauryl ether, 2-biphenylglycidyl ether, 1,2-epoxycyclohexane, 1-methyl-1,2-epoxycyclohexane, 2,3-epoxynorbornane; and divalent epoxy compounds such as 1,5-hexadiene diepoxide, 1,7-octadiene diepoxide, and bisphenol A diglycidyl ether. In a case in which an epoxy is used as an esterifying agent, a substituent containing a carboxylic acid derivative generated after reaction is an ester group and has a hydroxyl group. Monovalent epoxy compounds do not cause a decrease in fluidity, and thus, are more preferable.

Alcohols refer to compounds having a hydroxyl group, and examples thereof include methanol, ethanol, 1-propanol, 2-propanol, 1-butanol, 2-butanol, 2,2-dimethyl-1-propanol (t-butylalcohol), 2-methyl-1-butanol, 3-methyl-1-butanol, 1-pentanol, 2-pentanol, 3-pentanol, 2-methyl-1-pentanol, 3-methyl-1-pentanol, 4-methyl-1-pentanol, 1-hexanol, 2-hexanol, 3-hexanol, 2-methyl-1-hexanol, 3-methyl-1-hexanol, 4-methyl-1-hexanol, 5-methyl-1-hexanol, and benzyl alcohol.

Examples of monovalent phenols include phenols, 3-methylphenol, 3-t-butylphenol, 3,5-dimethylphenol, 3,4,5-trimethylphenol, dibutylhydroxytoluene, cresol, eugenol, guaiacol, thymol, methyl salicylate, and propofol.

Examples of dimethylformamide dialkylacetals include N,N-dimethylformamide dimethylacetal, N,N-dimethylformamide diethylacetal, N,N-dimethylformamide dipropylacetal, N,N-dimethylformamide dibutylacetal, N,N-dimethylformamide di-t-butylacetal, N,N-dimethylformamide dipentylacetal, and N,N-dimethylformamide dihexylacetal.

Examples of alkyl halides include methyl bromide, methyl iodide, ethyl bromide, ethyl iodide, propyl bromide, propyl iodide, butyl bromide, and butyl iodide.

Examples of alkyl carbonates include dimethyl carbonate, diethyl carbonate, dipropyl carbonate, and dibutyl carbonate.

A preferable esterifying agent is a compound selected from ortho esters, oxazolines, epoxy compounds, alcohols, monovalent phenols, alkyl halides, and alkyl carbonates since these do not cause a decrease in fluidity. A compound selected from ortho esters, oxazolines, and alkyl carbonates is more preferable since these undergo reaction without any catalyst. Ortho esters are preferable from the viewpoint of having a high effect of lowering the modulus of elasticity. Among ortho esters, trimethyl orthoformate, trimethyl orthoacetate, triethyl orthoformate, triethyl orthoacetate, tripropyl orthoformate, and tripropyl orthoacetate are preferable since these have excellent dispersibility in a cured epoxy resin. Oxazolines are preferable from the viewpoint of having excellent dispersibility in a cured epoxy resin. Among oxazolines, 2-methyl-2-oxazoline, 2-ethyl-2-oxazoline, and 2-phenyl-2-oxazoline are preferable. In some cases, use of a dimethylformamide dialkylacetal causes a decrease in fluidity, and thus, is not preferable.

Examples of amidating agents include amines. Specific examples thereof include methylamine, ethylamine, propylamine, butylamine, isobutylamine, t-amylamine, isoamylamine, s-butylamine, pentaneamine, 3-aminopentane, neopentylamine, 2-methylbutylamine, hexylamine, heptylamine, 3,3-dimethyl-2-butylamine, octylamine, nonylamine, 1-aminodecane, aniline, o-toluidine, m-toluidine, p-toluidine, 4-ethylaniline, 4-isopropylaniline, 4-t-butylaniline, 2,3-dimethylaniline, 2,5-dimethylaniline, 2,6-dimethylaniline, 3,4-dimethylaniline, 3,5-dimethylaniline, 2,4,6-trimethylaniline, 1-aminoanthracene, 2-aminoanthracene, 9-aminoanthracene, and 1-aminopyrene. If remaining unreacted, however, amines can lead to poor fluidity, and thus, such amines remaining unreacted after reaction are preferably removed by purification or drying so sufficiently as to fall within a range which causes no decrease in fluidity.

Incidentally, the above-mentioned compounds reactive with a carboxyl group may be used singly, or may be used in combination of two or more kinds thereof.

In some of the cases in which the reaction between a compound reactive with a carboxyl group and a carboxyl group generates a byproduct and in which the byproduct remains after an epoxy resin is mixed in, an unexpected side reaction causes a decrease in fluidity, and bubbles intrude into the cured epoxy resin, leading to a decrease in mechanical strength. Thus, the byproduct is preferably removed by purification or drying so sufficiently as to fall within a range which causes no such influence. The removal by drying is convenient, and thus, the byproduct preferably has a boiling point of 130°C or less, more preferably 100°C or less, particularly preferably 80°C or less. The drying conditions vary depending on the boiling point of the byproduct, and the boiling point is preferably 200°C or less, more preferably 180°C or less, particularly preferably 150°C or less, under reduced pressure.

The addition amount of the compound reactive with a carboxyl group is not limited to any particular value provided that the carboxyl group content of the polysiloxane-polyalkylene glycol block copolymer to be obtained falls within a desired range, and the addition amount is preferably 0.1 to 3.0 equivalents, still more preferably 0.2 to 2.0 equivalents or 0.4 to 1.5 equivalents, particularly preferably 0.7 to 1.0 equivalents, with respect with the carboxyl group content of the block copolymer intermediate existing before the compound is allowed to react. As below-mentioned, the carboxyl group content can be determined by known titrimetry. For example, the block copolymer is dissolved in toluene or tetrahydrofuran, and the content is calculated from a value obtained by titration conducted with 0.1 mol/L alcoholic potassium hydroxide using phenolphthalein as an indicator.

As the polysiloxane (A) having a functional group, a polysiloxane represented by Formula (1) can be used.

[Chem. 1]

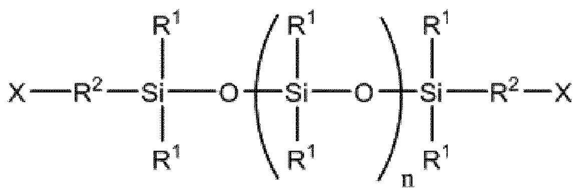

・・・(1)

In the formula, n denotes the number of repeating units from 5 to 100. X denotes a functional group selected from a carboxylic anhydride group, a hydroxyl group, an epoxy group, an amino group, and a thiol group. Here, the carboxylic anhydride group also includes cyclic carboxylic anhydride groups such as maleic anhydride, phthalic anhydride, and succinic anhydride. In addition, $R^1$ denotes a hydrogen atom, an alkyl group having 1 to 5 carbon atoms, or a phenyl group. $R^2$ denotes a group selected from a single bond, a divalent aliphatic or aromatic hydrocarbon group having 1 to 10 carbon atoms, and a divalent hydrocarbon ether group having 1 to 10 carbon atoms. Here, a single bond means that $R^2$ does not exist but silicon and X are directly bonded to each other. In addition, $R^2$ is preferably a butylene group, a

propylene group, or an ethylene group, most preferably a propylene group or an ethylene group, from the viewpoint of improving dispersibility of the block copolymer in a cured epoxy resin. In addition, the bonding position of X with $R^2$ or silicon atom may be any position in a case in which X denotes a cyclic carboxylic anhydride group. In addition, the divalent hydrocarbon ether group is preferably a group represented by $-(CH_2)_a-O-(CH_2)_b-$, where $1 \leq a + b \leq 10$. All $R^1$s and all $R^2$s and all Xs may be the same as or different from one another, respectively.

$R^1$ in Formula (1) denotes a hydrogen atom, an alkyl group having 1 to 5 carbon atoms, or a phenyl group, and is preferably a group which does not react with any one of X, Y, and the copolymerization component (C). It is not preferable that $R^1$ reacts with any one of X, Y, and the copolymerization component (C) since the reaction of X with Y is inhibited or a crosslinking reaction proceeds. In addition, it is not preferable that the chain length of $R^1$ is too long since the molding-processability is decreased when the polysiloxane-alkylene glycol block copolymer obtained is added to an epoxy resin and results in having a higher viscosity. $R^1$ is preferably any of a propyl group, an ethyl group, or a methyl group, more preferably an ethyl group or a methyl group, and most preferably a methyl group. In addition, all $R^1$s may be different from or the same as one another.

The polysiloxane (A) having a functional group is preferably a polyorganosiloxane having a functional group and particularly preferably polydimethylsiloxane having a functional group.

The weight average molecular weight of the polysiloxane (A) having a functional group is not particularly limited, but the lower limit value thereof is preferably 500 or more, more preferably 800 or more, and still more preferably 1,000 or more. In addition, the upper limit value of the weight average molecular weight is preferably 8,000 or less, more preferably 5,000 or less, still more preferably 4,000 or less, and most preferably 3,000 or less. In a case in which the weight average molecular weight of the polysiloxane (A) having a functional group is low, the effect on lowering the modulus of elasticity is minor even when the polysiloxane-polyalkylene glycol block copolymer obtained is added to an epoxy resin. In addition, in a case in which the weight average molecular weight of the polysiloxane (A) having a functional group is high, the polysiloxane (A) having a functional group and the polyalkylene glycol (B) having a functional group undergo phase separation, the reaction does not proceed in a uniform state, and thus the reactivity of the polysiloxane (A) with the polyalkylene glycol (B) having a functional group deteriorates. Incidentally, the weight average molecular weight of the polysiloxane (A) having a functional group refers to a weight average molecular weight measured by gel permeation chromatography using tetrahydrofuran (THF) as a solvent and determined in terms of polymethyl methacrylate.

Examples of the polysiloxane (A) having a functional group include X-22-168AS, KF-105, X-22-163A, X-22-163B, X-22-163C, KF-8010, X-22-161A, X-22-161B, KF-8012, X-22-169AS, X-22-169B, X-22-160AS, KF-6001, KF-6002, KF-6003, X-22-1821, X-22-167B, X-22-167C, X-22-163, KF-6000, PAM-E, KF-8008, X-22-168A, X-22-168B, X-22-168-P5-B, X-22-1660B-3, and X-22-9409 which are commercially available from Shin-Etsu Chemical Co., Ltd. and BY16-871, BY16-853U, BY16-855, and BY16-201 which are commercially available from Dow Corning Toray Co., Ltd.

In addition, the polyalkylene glycol (B) having a functional group, it is preferable to use a polyalkylene glycol represented by Formula (2).

[Chem. 2]

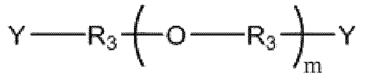 ・・・(2)

In the formula, m denotes the number of repeating units from 3 to 300. Y denotes a functional group selected from a carboxylic anhydride group, a hydroxyl group, an amino group, an epoxy group, and a thiol group. Here, the carboxylic anhydride group also includes cyclic carboxylic anhydride groups such as maleic anhydride, phthalic anhydride, and succinic anhydride. $R^3$ denotes a linear or branched alkyl group having 2 to 10 carbon atoms. It is not preferable that $R^3$ has more than 10 carbon atoms since such a case causes the polyalkylene glycol (B) having a functional group to be not compatible with an epoxy resin, with the result that the polysiloxane-polyalkylene glycol block copolymer to be obtained has lower dispersibility in the cured epoxy resin. In addition, it is not preferable that $R^3$ has less than two carbon atoms since the flexibility is diminished. The preferred number of carbon atoms in $R^3$ is 3 or 4. All $R^3$s and all Ys may be the same as or different from one another, respectively.

In a case in which the functional group of the polysiloxane (A) is a carboxylic anhydride group, the polyalkylene glycol (B) having a functional group is preferably polytetramethylene glycol and/or polypropylene glycol since these exhibit excellent reactivity with the polysiloxane (A), the reaction proceeds without using a metal catalyst as a reaction accelerator, and the polysiloxane (A) and the polyalkylene glycol (B) can react with each other without using an organic solvent to obtain a homogeneous block copolymer intermediate. Polytetramethylene glycol is more preferable particularly from the viewpoint of improving heat resistance.

The weight average molecular weight of the polyalkylene glycol (B) having a functional group is not particularly

limited, but the lower limit value thereof is preferably 300 or more, more preferably 500 or more, and still more preferably 1,000 or more. In addition, the upper limit value of the weight average molecular weight is preferably 20,000 or less, more preferably 10,000 or less, still more preferably 5,000 or less, and most preferably 3,000 or less. In a case in which the weight average molecular weight of the polyalkylene glycol (B) having a functional group is low, the effect on lowering the modulus of elasticity is minor when the polysiloxane-polyalkylene glycol block copolymer obtained is added to an epoxy resin. In addition, in a case in which the weight average molecular weight of the polyalkylene glycol (B) having a functional group is high, the polysiloxane (A) having a functional group and the polyalkylene glycol (B) having a functional group undergo phase separation, the reaction does not proceed in a uniform state, and thus the reactivity of the polyalkylene glycol (B) with the polysiloxane (A) having a functional group deteriorates. Incidentally, the weight average molecular weight of the polyalkylene glycol (B) having a functional group refers to a weight average molecular weight measured by gel permeation chromatography using tetrahydrofuran (THF) as a solvent and determined in terms of polymethyl methacrylate.

In addition to the polysiloxane (A) and the polyalkylene glycol (B), a copolymerization component (C) capable of reacting with these may be further added and reacted in a range in which the flexibility of the polysiloxane-alkylene glycol block copolymer to be obtained and good dispersibility to an epoxy resin are not impaired.

The copolymerization component (C) mentioned here is a compound having one or more functional groups which react with the functional group of the polysiloxane (A) and/or the functional group of the polyalkylene glycol (B). In this case, the block copolymer to be obtained has a structure derived from the copolymerization component (C) in addition to a structure derived from the polysiloxane (A) and a structure derived from the polyalkylene glycol (B).

It is preferable that this copolymerization component (C) is dissolved in both the polysiloxane (A) and the polyalkylene glycol (B) at the time of the reaction since the reaction is likely to proceed. In addition, plural kinds of copolymerization components (C) may be used.

Examples of copolymerization components (C) include mono- or di-carboxylic anhydrides, diols, alcohols, monovalent or divalent phenols, diamines, amines, dithiols, thiols, isocyanates, and epoxies.

Specific examples of the monocarboxylic anhydrides include succinic anhydride, phthalic anhydride, maleic anhydride, acetic anhydride, propionic anhydride, oxalic anhydride, and benzoic anhydride.

Examples of dicarboxylic anhydrides include: carboxylic dianhydrides containing an aromatic ring, such as pyromellitic dianhydride, 4,4'-oxydiphthalic anhydride, 3,3',4,4'-biphenyltetracarboxylic dianhydride, 2,2'-dimethyl-3,3',4,4'-biphenyltetracarboxylic dianhydride, 5,5'-dimethyl-3,3',4,4'-biphenyltetracarboxylic dianhydride, 2,3,3',4'-biphenyltetracarboxylic dianhydride, 2,2',3,3'-biphenyltetracarboxylic dianhydride, and 3,3',4,4'-diphenyl ether tetracarboxylic dianhydride; and carboxylic dianhydrides containing an aliphatic chain, such as 1,2,3,4-butanetetracarboxylic acid, 2,3,5-tricarboxycyclopentylacetic dianhydride, 1,2,3,4-cyclobutanetetracarboxylic dianhydride, 1,2,3,4-cyclopentanetetracarboxylic dianhydride, 1,2,3,5-cyclopentanetetracarboxylic dianhydride, 1,2,4,5-cyclohexanetetracarboxylic dianhydride, and 1,3,3a,4,5,9b-hexahydro-5(tetrahydro-2,5-dioxo-3-furanyl)naphtho[1,2-c]furan-1,3-dione.

Examples of diols include ethylene glycol, 1,2-propylene glycol, 1,3-propylene glycol, 1,2-butanediol, 1,3-butanediol, 1,4-butanediol, 1,5-pentanediol, 3-methyl-1,5-pentanediol, 1,6-hexanediol, neopentyl glycol, 1,8-octanediol, 1,9-nonanediol, 1,4-cyclohexanediol, and diethylene glycol. In a case in which the diol is an aliphatic diol, it is more preferable that the molecular chain is longer since the flexibility of the polysiloxane-polyalkylene glycol block copolymer to be obtained is not impaired.

Examples of the alcohols include methanol, ethanol, isopropyl alcohol, butanol, pentanol, hexanol, octanol, dodecanol, tetradecanol, hexadecanol, and octadecanol.

Examples of monovalent phenols are as above-mentioned.

Examples of divalent phenols include bisphenol A, bisphenol AP, bisphenol AF, bisphenol B, and bisphenol BP.

Examples of diamines include ethanediamine, 1,2-propylenediamine, 1,3-propylenediamine, 1,2-butanediamine, 1,3-butanediamine, 1,4-butanediamine, 1,5-pentanediamine, 3-methyl-1,5-pentanediamine, 1,6-hexanediamine, 2,2-dimethyl-1,3-propanediamine, 1,8-octanediamine, 1,9-nonanediamine, 1,4-cyclohexanediamine, 1,4-benzenediamine, and 1,4-benzenedimethaneamine.

Examples of amines are as above-mentioned. If remaining unreacted, diamines or amines can lead to poor fluidity, and thus, such amines remaining unreacted after reaction are preferably removed by purification or drying so sufficiently as to fall within a range which causes no decrease in fluidity.

Examples of dithiols include ethanedithiol, 1,2-propylenedithiol, 1,3-propylenedithiol, 1,2-butanedithiol, 1,3-butanedithiol, 1,4-butanedithiol, 1,5-pentanedithiol, 3-methyl-1,5-pentanedithiol, 1,6-hexanedithiol, 2,2-dimethyl-1,3-propanedithiol, 1,8-octanedithiol, 1,9-nonanedithiol, 1,4-cyclohexanedithiol, 1,4-benzenedithiol, and 1,4-benzenedimethanethiol.

Examples of thiols include 1-ethanethiol, 1-propylenethiol, 2-propylenethiol, 1-butanethiol, 2-butanethiol, 1-pentanethiol, 1-hexanethiol, 1-heptanethiol, 1-octanethiol, 1-nonanethiol, 1-cyclohexanethiol, benzenethiol, and benzyl mercaptan.

Examples of isocyanates include phenetyl isocyanate, 1,4-phenylene diisocyanate, and hexamethylene diisocyanate.

Examples of epoxies are as above-mentioned.

The molecular weight of the block copolymer to be obtained decreases as the amount of the copolymerization component (C) added increases in a case in which the copolymerization component (C) has one functional group. The molecular weight of the block copolymer increases in a case in which the copolymerization component has two functional groups.

The copolymerization component (C) is preferably such that the reaction proceeds even without using a metal catalyst as a reaction accelerator. Furthermore, it is preferable from the viewpoint of enhancing the dispersibility in a cured epoxy resin that the copolymerization component (C) is one into which a carboxyl group can be introduced at the same time. Examples thereof include mono- or di-carboxylic anhydrides in a case in which the functional group of the polysiloxane (A) is a carboxylic anhydride group and the functional group of the polyalkylene glycol (B) is a hydroxyl group.

In a case in which the functional group of the polysiloxane (A) is a carboxylic anhydride group and the polyalkylene glycol (B) is polytetramethylene glycol and a case in which the functional group of the polysiloxane (A) is a hydroxyl group and the polyalkylene glycol (B) is polypropylene glycol, examples of the copolymerization component (C) include pyromellitic dianhydride, 3,3',4,4'-benzophenonetetracarboxylic dianhydride, 4,4'-(4,4'-isopropylidenediphenoxy)diphthalic anhydride, 4,4'-oxydiphthalic anhydride, and 3,3',4,4'-biphenyltetracarboxylic dianhydride, since these are dissolved in the polysiloxane (A) and polytetramethylene glycol or polypropylene glycol and thus the reactivity increases. Among these, pyromellitic dianhydride is preferable from the viewpoint that this is easily dissolved in the polysiloxane (A) and the polyalkylene glycol (B), the system is thus in a uniform state, and the reaction proceeds even without using a metal catalyst as a reaction accelerator.

Incidentally, the copolymerization components (C) may be used singly, or may be used in combination of two or more kinds thereof.

The addition amount of the copolymerization component (C) is not limited to any particular value, and in order to cause no influence on the properties of the polysiloxane-polyalkylene glycol block copolymer of the present invention, the upper limit is preferably 40% by mass or less, more preferably 30% by mass or less, still more preferably 20% by mass or less, most preferably 10% by mass or less, with respect to 100% by mass of the entire polysiloxane-polyalkylene glycol block copolymer. It is not preferable that the amount added is greater than this range since the flexibility of the polysiloxane-polyalkylene glycol block copolymer to be obtained is impaired, also the curing reaction of the block copolymer with an epoxy resin is accelerated as the unreacted copolymerization component (C) exists, and the fluidity is diminished.

In a case in which the polysiloxane (A) having a functional group and the polyalkylene glycol (B) having a functional group do not directly react with each other, a method may be used in which the copolymerization component (C) (hereinafter, particularly referred to as copolymerization component (C')) in some cases) which reacts with both the functional group of the polysiloxane (A) and the functional group of the polyalkylene glycol (B) is added and the polysiloxane (A), the polyalkylene glycol (B), and the copolymerization component (C') are reacted with one another.

The copolymerization component (C') is not particularly limited as long as it is one that reacts with both the polysiloxane (A) having a functional group and the polyalkylene glycol (B) having a functional group among the copolymerization components (C). Examples of the copolymerization component (C') include dicarboxylic anhydrides, diols, divalent phenols, diamines, dithiols, and divalent epoxy compounds. In a case in which the functional group of each of the polysiloxane (A) and the polyalkylene glycol (B) is a hydroxyl group, an epoxy group, an amino group, or a thiol group, the copolymerization component (C') is preferably a dicarboxylic anhydride, which, in this case, makes it possible to introduce a carboxyl group and enhance the dispersibility in the cured epoxy resin. Among others, the copolymerization component (C') is preferably a carboxylic anhydride selected from pyromellitic dianhydride, 3,3',4,4'-benzophenonetetracarboxylic dianhydride, 4,4'-(4,4'-isopropylidenediphenoxy)diphthalic anhydride, 4,4'-oxydiphthalic anhydride, and 3,3',4,4'-biphenyltetracarboxylic dianhydride. Pyromellitic dianhydride is most preferable from the viewpoint that flexibility can be imparted to the polysiloxane-polyalkylene glycol block copolymer to be obtained and copolymerization can be conducted without using an organic solvent. Two or more copolymerization components (C') may be used. In a case in which the functional group of each of the polysiloxane (A) and the polyalkylene glycol (B) is a carboxylic anhydride group, the copolymerization component (C') is preferably a compound selected from diols, diamines, dithiols, divalent phenols, and divalent epoxy compounds, more preferably from diols and divalent phenols.

The content of a structure derived from the copolymerization component (C') in the polysiloxane-polyalkylene glycol block copolymer is preferably 30% by mass or less with respect to 100% by mass of the entire polysiloxane-polyalkylene glycol block copolymer. If the content of a structure derived from the copolymerization component (C') is great, the effect on lowering the modulus of elasticity of the polysiloxane-polyalkylene glycol block copolymer is decreased. If the content is low, the dispersibility in a cured epoxy resin is decreased. The content is preferably 25% by mass or less, more preferably 20% by mass or less, particularly preferably 15% by mass or less, and most preferably 10% by mass or less.

The polysiloxane-polyalkylene glycol block copolymer of the present invention preferably has a structure rep-

resented by Formula (3).

[Chem. 3]

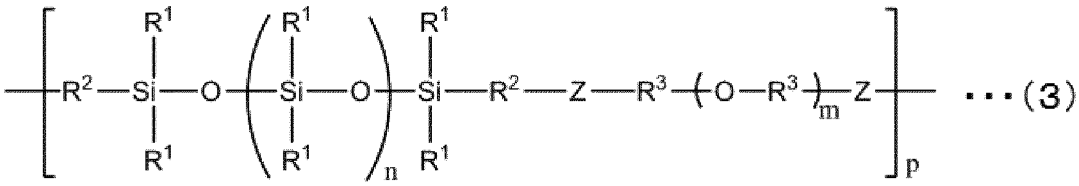

Here, n denotes the number of repeating units from 5 to 100, m denotes the number of repeating units from 3 to 300, and p denotes the number of repeating units from 5 to 100. In addition, $R^1$ denotes a hydrogen atom, an alkyl group having 1 to 5 carbon atoms, or a phenyl group. It is not preferable that the chain length of $R^1$ is longer than above-mentioned since the molding-processability is decreased when the polysiloxane-polyalkylene glycol block copolymer obtained is added to an epoxy resin and results in having a higher viscosity. $R^1$ is preferably any of a propyl group, an ethyl group, or a methyl group, more preferably an ethyl group or a methyl group, and most preferably a methyl group. In addition, all $R^1$s may be different from or the same as one another. Z denotes a bonding site to be formed by the reaction of the polysiloxane (A) having a functional group with the polyalkylene glycol having a functional group. In a case in which the polysiloxane (A) and the polyalkylene glycol (B) directly react with each other to be bonded to each other, the residue obtained by the reaction of the X of the polysiloxane (A) with the Y of the polyalkylene glycol (B) is the bonding site Z. In addition, in a case in which the polysiloxane (A) and the polyalkylene glycol (B) do not directly react with each other but are bonded to each other via the copolymerization component (C'), the residue obtained by the reaction of the X of the polysiloxane (A) and the Y of the polyalkylene glycol (B) with the copolymerization component (C') is the bonding site Z. As a result of this reaction, the bonding site Z has a bond selected from an ester bond, an amide bond, and a thioester bond. Among these bonds, an ester bond and a thioester bond are preferable from the viewpoint of viscosity, and an ester bond is more preferable from the viewpoint of heat resistance. Furthermore, Z also contains a carboxyl group newly generated as a result of this reaction. The carboxyl group may be a substituent which has been caused to contain a carboxylic acid derivative by a reaction with the above-mentioned compound reactive with a carboxyl group. In addition, all Zs may be the same as or different from one another. $R^2$ denotes a group selected from a single bond, a divalent aliphatic or aromatic hydrocarbon group having 1 to 10 carbon atoms, and a divalent hydrocarbon ether group having 1 to 10 carbon atoms. Here, a single bond means that $R^2$ does not exist but silicon and Z are directly bonded to each other. In addition, $R^2$ is preferably butylene, propylene, or ethylene, most preferably propylene or ethylene, from the viewpoint of improving dispersibility of the block copolymer in a cured epoxy resin. $R^2$s may be the same as or different from one another. In addition, the divalent hydrocarbon ether group is preferably a group represented by $-(CH_2)_a-O-(CH_2)_b-$, where $1 \leq a + b \leq 10$. All $R^1$s and all $R^2$s may be the same as or different from one another, respectively.

A substituent containing a carboxylic acid derivative refers to a substituent generated by a reaction between a carboxyl group and a compound reactive with a carboxyl group, and examples thereof include ester groups and amide groups. An ester group refers to a group represented by a structure represented by the following Formula (4).

[Chem. 4]

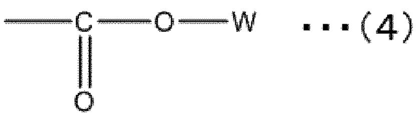

Here, W denotes an alkyl group having 1 to 10 carbon atoms, or an aromatic hydrocarbon group. W may have a hydroxyl group, an ether group, and/or an ether amide group. Specific examples of alkyl groups having 1 to 10 carbon atoms include a methyl group, an ethyl group, a propyl group, an isopropyl group, a butyl group, a t-butyl group, a pentyl group, a neopentyl group, a hexyl group, a heptyl group, an octyl group, a nonyl group, a decyl group, a cyclobutyl group, a cyclopentyl group, a cyclohexyl group, a cycloheptyl group, a cyclooctyl group, a cyclononyl group, and a cyclodecyl group, and such a group may have a linear structure or a branched structure. In addition, examples of aromatic hydrocarbon groups include a phenyl group, a tolyl group, and a naphthyl group. W may further contain a substituent if such a substituent causes no influence on the effect on lowering the modulus of elasticity of the polysiloxane-polyalkylene glycol block copolymer, the good dispersibility in a cured epoxy resin, and the fluidity.

An amide group refers to a group having a structure represented by the following Formula (5).

[Chem. 5]

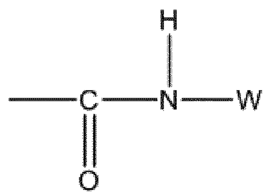
···(5)

Here, W is as the above-mentioned.

The lower limit value of the content of a polysiloxane-derived structure in the polysiloxane-polyalkylene glycol block copolymer of the present invention is 30% by mass or more, more preferably 35% by mass or more, still more preferably 40% by mass or more, most preferably 45% by mass or more, with respect to 100% by mass of the entire polysiloxane-polyalkylene glycol block copolymer. In addition, the upper limit value of the content is 70% by mass or less, more preferably 65% by mass or less, still more preferably 60% by mass or less, most preferably 55% by mass or less. In a case in which the content of the polysiloxane-derived structure is too small, adding the polysiloxane-polyalkylene glycol block copolymer to an epoxy resin to produce a cured product only brings about the result that the effect of lowering the modulus of elasticity by the addition of the polysiloxane-polyalkylene glycol block copolymer is low. In addition, in a case in which the content of the polysiloxane-derived structure is too large, adding the polysiloxane-polyalkylene glycol block copolymer to an epoxy resin does not allow the polysiloxane-polyalkylene glycol block copolymer to be well dispersed in a cured epoxy resin.

The content of the polysiloxane-derived structure in the polysiloxane-polyalkylene glycol block copolymer can be determined by dividing the weight of the polysiloxane (A) having a functional group by the weight of all raw materials in synthesis of the block copolymer. Incidentally, in a case in which the process of synthesizing the block copolymer generates a byproduct, the weight of the generated byproduct is subtracted from the weight of all raw materials in the calculation. That is, the content of the polysiloxane-derived structure can be determined by the following equation.

[Math. 1]

$$\text{Content of structure derived from polysiloxane (A) (\% by mass)} = \frac{\textit{Weight of polysiloxane (A)}}{\textit{Weight of all raw materials} - \textit{Weight of byproduct}} \times 100$$

The polysiloxane-polyalkylene glycol block copolymer of the present invention has a carboxyl group content of 0.1 mmol/g or more and 0.75 mmol/g or less. The lower limit value of the carboxyl group content is more preferably 0.2 mmol/g or more, still more preferably 0.3 mmol/g or more, particularly preferably 0.4 mmol/g or more, most preferably 0.45 mmol/g or more. In addition, the upper limit value thereof is more preferably 0.7 mmol/g or less, still more preferably 0.65 mmol/g or less, and particularly preferably 0.6 mmol/g or less.

It is not preferable that the carboxyl group content is larger than this range, since such a case causes the effect of lowering the modulus of elasticity to be decreased when the polysiloxane-polyalkylene glycol block copolymer of the present invention is added to produce a cured epoxy resin. It is not preferable that the carboxyl group content is smaller than this range, since such a case causes the dispersibility in a cured epoxy resin to be decreased, and causes the polysiloxane-polyalkylene glycol block copolymer to be coarsely dispersed in the cured epoxy resin.

The carboxyl group content can be determined by known titrimetry. For example, the polysiloxane-polyalkylene glycol block copolymer is dissolved in toluene or tetrahydrofuran, and the content is calculated from a value obtained by titration conducted with 0.1 mol/L alcoholic potassium hydroxide using phenolphthalein as an indicator.

The weight average molecular weight ($M_w$) of the polysiloxane-polyalkylene glycol block copolymer of the present invention is not particularly limited, but the lower limit value thereof is preferably 5,000 or more, more preferably 6,000 or more, more preferably 8,000 or more, more preferably 10,000 or more, more preferably 15,000 or more, still more preferably 20,000 or more, and particularly preferably 30,000 or more from the viewpoint of mechanical properties and molding-processability of a cured epoxy resin to which the polysiloxane-polyalkylene glycol block copolymer is added. In addition, the upper limit value thereof is preferably 500,000 or less, more preferably 200,000 or less, more preferably 150,000 or less, still more preferably 100,000 or less, and most preferably 80,000 or less. In a case in which the weight average molecular weight is lower than this range, the effect of lowering the modulus of elasticity of a cured epoxy resin to which the polysiloxane-polyalkylene glycol block copolymer is added is diminished. It is not preferable that the weight average molecular weight is higher than this range, since the viscosity of an epoxy resin composition

added to an epoxy resin is increased, and the epoxy resin composition does not penetrate into the fine portions at the time of molding of the encapsulating material, whereby cracking is caused.

Incidentally, the weight average molecular weight of the polysiloxane-polyalkylene glycol block copolymer mentioned here refers to a weight average molecular weight measured by gel permeation chromatography using tetrahydrofuran (THF) as a solvent and determined in terms of polymethyl methacrylate used as a standard sample.

N,N-dimethylformamide is used as a solvent in a case in which the weight average molecular weight cannot be measured using tetrahydrofuran (THF) as a solvent, and hexafluoroisopropanol is used in a case in which the weight average molecular weight cannot be still measured using dimethylformamide.

The number average molecular weight ($M_n$) of the polysiloxane-polyalkylene glycol block copolymer of the present invention is not particularly limited, but the lower limit value thereof is 1,000 or more, preferably 2,000 or more, more preferably 5,000 or more, still more preferably 10,000 or more, still more preferably 15,000 or more, still more preferably 20,000 or more, and particularly preferably 30,000 or more from the viewpoint of mechanical properties and molding-processability of a cured epoxy resin to which the polysiloxane-polyalkylene glycol block copolymer is added. In addition, the upper limit thereof is preferably 500,000 or less, more preferably 200,000 or less, more preferably 150,000 or less, still more preferably 100,000 or less, and most preferably 80,000 or less. In a case in which the weight average molecular weight is lower than this range, the effect of lowering the modulus of elasticity of a cured epoxy resin to which the polysiloxane-polyalkylene glycol block copolymer is added is diminished. It is not preferable that the weight average molecular weight is higher than this range, since the viscosity of an epoxy resin composition added to an epoxy resin is increased, and the epoxy resin composition does not penetrate into the fine portions at the time of molding of the encapsulating material, whereby cracking is caused. The number average molecular weight can be measured by gel permeation chromatography in the same manner as the weight average molecular weight.

In addition, the molecular weight distribution ($M_w/M_n$) of the polysiloxane-polyalkylene glycol block copolymer of the present invention is preferably 5 or less, more preferably 3 or less, and still more preferably 2 or less. The lower limit value of the molecular weight distribution is theoretically 1. Incidentally, the molecular weight distribution ($M_w/M_n$) is calculated from the weight average molecular weight ($M_w$) and number average molecular weight ($M_n$) measured as described above by gel permeation chromatography.

The polysiloxane-polyalkylene glycol block copolymer of the present invention has two kinds of flexible polymer skeletons and a carboxyl group content of 0.1 to 0.75 mmol/g, and thus, makes it possible that a cured product obtained by adding the copolymer to an epoxy resin expresses a marked effect of lowering the modulus of elasticity. Causing the polysiloxane-polyalkylene glycol block copolymer of the present invention to be well dispersed in the cured epoxy resin makes it possible that the material properties have no variation, and that adding the polysiloxane-polyalkylene glycol block copolymer in a small amount causes the cured epoxy resin to efficiently achieve a decrease in the modulus of elasticity, and alleviates the internal stress.

In a method for producing a polysiloxane-polyalkylene glycol block copolymer of the present invention, the below-mentioned step (1) is followed by the below-mentioned step (2):

the step (1): reacting a polysiloxane (A) having a functional group selected from a carboxylic anhydride group, a hydroxyl group, an epoxy group, an amino group, and a thiol group with a polyalkylene glycol (B) having a functional group selected from a carboxylic anhydride group, a hydroxyl group, an amino group, an epoxy group, and a thiol group to obtain a polysiloxane-polyalkylene glycol block copolymer intermediate; and

the step (2): reacting a carboxyl group of the polysiloxane-polyalkylene glycol block copolymer intermediate obtained in the step (1) with a compound reactive with a carboxyl group, wherein the compound reactive with a carboxyl group is at least one selected from ortho esters, oxazolines, epoxies, alcohols, monovalent phenols, alkyl halides, and alkyl carbonates.

According to a conventional method in which a carboxyl group is introduced into a copolymer, a functional group is introduced as a reaction residue into the molecular chain, and thus, a carboxyl group is introduced into both ends of the molecular chain, that is, two carboxyl groups are introduced in one molecular chain. Reacting the polysiloxane (A) having a functional group with the polyalkylene glycol (B) having a functional group enables the polysiloxane-polyalkylene glycol block copolymer of the present invention to contain at least three or more functional groups in one molecular chain. It is more preferably 5 or more, more preferably 10 or more, more preferably 10 or more, still more preferably 20 or more. That is, the product of a number average molecular weight and a carboxyl group content is preferably larger than 2 for the polysiloxane-polyalkylene glycol block copolymer of the present invention. It is more preferably 3 or more, more preferably 5 or more, still more preferably 10 or more, and particularly preferably 20 or more.

Examples of methods of reacting the polysiloxane (A) having a functional group with the polyalkylene glycol (B) having a functional group include a method in which the polysiloxane (A) and the polyalkylene glycol (B) having a functional group are mixed together and heated for reaction. If necessary, they may be allowed to react in an organic solvent. Moreover, the reaction may be conducted in a nitrogen atmosphere if necessary, and the reaction may be

conducted under reduced pressure in order to accelerate the reaction.

In addition, the mixing ratio between the polysiloxane (A) having a functional group and the polyalkylene glycol (B) having a functional group can be appropriately adjusted but is preferably a mixing ratio so that the stoichiometric equivalent ratio is between 0.1 and 10 in a case in which the polysiloxane (A) having a functional group and the polyalkylene glycol (B) having a functional group directly react with each other to be bonded to each other. Here, the stoichiometric equivalent ratio refers to the ratio of the number of moles of functional groups contained in the polyalkylene glycol (B) to the number of moles of functional groups contained in the polysiloxane (A). The equivalence ratio is more preferably 0.2 to 5, still more preferably 0.5 to 3, most preferably 0.8 to 1.5, and remarkably preferably 1.

On the other hand, in a case in which the polysiloxane (A) having a functional group and the polyalkylene glycol (B) having a functional group do not directly react with each other but are bonded to each other as the copolymerization component (C) reacts with the polysiloxane (A) and the polyalkylene glycol (B), the equivalent ratio of the number of moles of functional groups contained in the copolymerization component (C) to the total number of moles of functional groups contained in the polysiloxane (A) and the polyalkylene glycol (B) is more preferably 0.2 to 5, still more preferably 0.5 to 3, still more preferably 0.8 to 1.5, and most preferably 1.

Incidentally, in order to set the content of a structure derived from the polysiloxane (A) contained in 100% by mass of the polysiloxane-polyalkylene glycol block copolymer to be obtained to 30% by mass or more and 70% by mass or less, it is preferable that the raw materials are allowed to react at an adjusted mixing ratio when the block copolymer is synthesized.

In the case of using an organic solvent in the reaction, the organic solvent is preferably a good solvent for the polysiloxane (A) having a functional group and the polyalkylene glycol (B) having a functional group. Examples of organic solvents include hydrocarbon-based solvents such as toluene, xylene, benzene, and 2-methylnaphthalene; ester-based solvents such as ethyl acetate, methyl acetate, butyl acetate, butyl propionate, butyl butyrate, and ethyl acetoacetate; halogenated hydrocarbon-based solvents such as chloroform, bromoform, methylene chloride, carbon tetrachloride, 1,2-dichloroethane, 1,1,1-trichloroethane, chlorobenzene, 2,6-dichlorotoluene, and 1,1,1,3,3,3-hexafluoroisopropanol; ketone-based solvents such as acetone, methyl ethyl ketone, methyl isobutyl ketone, and methyl butyl ketone; alcohol-based solvents such as methanol, ethanol, 1-propanol, and 2-propanol; carboxylic acid solvents such as formic acid, acetic acid, propionic acid, butyric acid, and lactic acid; ether-based solvents such as anisole, diethyl ether, tetrahydrofuran, diisopropyl ether, dioxane, diglyme, and dimethoxyethane; or any mixture of these.

Among these, toluene, xylene, or ethyl acetate is preferable from the balance between the reaction rate and the solvent removal after reaction. In addition, these organic solvents may be used singly or in mixture of two or more kinds thereof.

Incidentally, when the reaction is conducted in an organic solvent, the organic solvent can be removed and purified by known methods such as heating, pressure reduction, and reprecipitation. A plurality of steps may be combined to remove the organic solvent.

However, it is preferable not to use an organic solvent since the productivity is improved from the viewpoint that a purification step for removing the organic solvent is not required and the production process is simple and the viewpoint that the reaction temperature can be increased and the reaction rate can be increased even in a system in which a metal catalyst as a reaction accelerator is not used.

The temperature at which the polysiloxane (A) having a functional group and the polyalkylene glycol (B) having a functional group are reacted is not particularly limited but is preferably 220°C or less, more preferably 200°C or less, still more preferably 180°C or less, and particularly preferably 150°C or less in order to suppress side reactions and polymer decomposition. In addition, it is difficult to stably store the block copolymer at room temperature in a case in which the reaction proceeds at room temperature or less, and thus it is preferable that the reaction does not proceed at room temperature or less. The lower limit value of the temperature at which the reaction is conducted is preferably 50°C or more, more preferably 70°C or more, and still more preferably 100°C or more.

Moreover, a reaction accelerator and the like may be added at the time of the reaction, but even without adding a reaction accelerator, the polysiloxane (A) having a functional group can easily be reacted with the polyalkylene glycol (B) having a functional group.

Moreover, the reaction time is preferably 20 hours or less, more preferably 15 hours or less, and still more preferably 10 hours or less from the viewpoint of productivity.

Next, the carboxyl group content is regulated to a desired value by reacting the carboxyl groups of the block copolymer intermediate obtained as above-mentioned with a compound reactive with a carboxyl group, and the polysiloxane-polyalkylene glycol block copolymer of the present invention is thus obtained. This reaction causes a part of the carboxyl groups to be capped, and thus, produces a substituent containing a carboxylic acid derivative. The compounds reactive with a carboxyl group are as above-mentioned.

A temperature at which a compound reactive with a carboxyl group is allowed to react with a carboxyl group depends on the compound used, is not limited to any particular value, and is preferably 220°C or less, more preferably 200°C or less, still more preferably 180°C or less, particularly preferably 150°C or less. In addition, it is difficult to stably

store the block copolymer at room temperature in a case in which the reaction proceeds at room temperature or less, and thus it is preferable that the reaction does not proceed at room temperature or less. The lower limit value of the temperature at which the reaction is conducted is preferably 50°C or more, more preferably 70°C or more, and still more preferably 100°C or more. The reaction may be advanced under reduced pressure conditions. In addition, a catalyst or a condensation agent may be added, but are preferably not added since the production efficiency is decreased by adding steps for purification and the like to remove such a material.

In the reaction with the compound reactive with a carboxyl group, the same solvent as used in the reaction of the polysiloxane (A) having a functional group with the polyalkylene glycol (B) having a functional group may be used. Incidentally, when the reaction is conducted in an organic solvent, the organic solvent can be removed and purified by known methods such as heating, pressure reduction, and reprecipitation. A plurality of steps may be combined to remove the organic solvent.

However, it is preferable not to use an organic solvent since the productivity is improved from the viewpoint that a purification step for removing the organic solvent is not required and the production process is simple and the viewpoint that the reaction temperature can be increased and the reaction rate can be increased even in a system in which a metal catalyst as a reaction accelerator is not used.

The lower limit value of the drying temperature for removing the organic solvent used for the reaction and the generated byproduct is not limited to any particular value, and is preferably 50°C or more, more preferably 80°C or more, still more preferably 100°C or more, in order that the removal can be carried out efficiently in a short time.

The epoxy resin composition of the present invention is a mixture of an epoxy resin to be described later and the block copolymer of the present invention and refers to a mixture before being subjected to a curing reaction.

A preferred amount of the polysiloxane-polyalkylene glycol block copolymer contained in the epoxy resin composition of the present invention is 0.1 to 50 parts by mass, more preferably 0.1 to 40 parts by mass, more preferably 0.5 to 30 parts by mass, and still more preferably 0.5 to 20 parts by mass with respect to 100 parts by mass of the epoxy resin. As the polysiloxane-polyalkylene glycol block copolymer is contained in the epoxy resin composition in this range, the internal stress can be efficiently relaxed in the cured epoxy resin obtained by curing the epoxy resin composition.

The epoxy resin is not particularly limited, but, for example, a glycidyl ether type epoxy resin obtained from a compound having a hydroxyl group and epichlorohydrin, a glycidylamine type epoxy resin obtained from a compound having an amino group and epichlorohydrin, a glycidyl ester type epoxy resin obtained from a compound having a carboxyl group and epichlorohydrin, an alicyclic epoxy resin obtained by oxidizing a compound having a double bond, or an epoxy resin in which two or more types of groups selected from these are present together in the molecule is used.

Specific examples of the glycidyl ether type epoxy resin include bisphenol A type epoxy resin obtained by the reaction of bisphenol A with epichlorohydrin, bisphenol F type epoxy resin obtained by the reaction of bisphenol F with epichlorohydrin, bisphenol S type epoxy resin obtained by the reaction of 4,4'-dihydroxydiphenylsulfone with epichlorohydrin, biphenyl type epoxy resin obtained by the reaction of 4,4'-biphenol with epichlorohydrin, resorcinol type epoxy resin obtained by the reaction of resorcinol with epichlorohydrin, phenol novolac type epoxy resin obtained by the reaction of phenol with epichlorohydrin, in addition to these, polyethylene glycol type epoxy resin, polypropylene glycol type epoxy resin, and regioisomers and alkyl group- and halogen-substituted products of these.

Commercially available products of bisphenol A type epoxy resin include "jER" (registered trademark) 825, "jER" (registered trademark) 826, "jER" (registered trademark) 827, and "jER" (registered trademark) 828 (all manufactured by Mitsubishi Chemical Corporation), "EPICLON" (registered trademark) 850 (manufactured by DIC Corporation), "Epotohto" (registered trademark) YD-128 (manufactured by NIPPON STEEL Chemical & material Co., Ltd.), D.E.R-331 (trademark) (manufactured by The Dow Chemical Company), and "Bakelite" (registered trademark) EPR154, "Bakelite" (registered trademark) EPR162, "Bakelite" (registered trademark) EPR172, "Bakelite" (registered trademark) EPR173, and "Bakelite" (registered trademark) EPR174 (all manufactured by Bakelite AG).

Commercially available products of bisphenol F type epoxy resin include "jER" (registered trademark) 806, "jER" (registered trademark) 807, and "jER" (registered trademark) 1750 (all manufactured by Mitsubishi Chemical Corporation), "EPICLON" (registered trademark) 830 (manufactured by DIC Corporation), "Epotohto" (registered trademark) YD-170 and "Epotohto" (registered trademark) YD-175 (manufactured by NIPPON STEEL Chemical & material Co., Ltd.), "Bakelite" (registered trademark) EPR169 (manufactured by Bakelite AG), and "Araldite" (registered trademark) GY281, "Araldite" (registered trademark) GY282, and "Araldite" (registered trademark) GY285 (all manufactured by Huntsman Advanced Materials).

Commercially available products of biphenyl type epoxy resin include "jER" (registered trademark) YX4000, "jER" (registered trademark) YX4000K, "jER" (registered trademark) YX4000H, "jER" (registered trademark) YX4000HK (all manufactured by Mitsubishi Chemical Corporation).

Commercially available products of resorcinol type epoxy resin include "Denacol" (registered trademark) EX-201 (manufactured by Nagase ChemteX Corporation).

Commercially available products of phenol novolac type epoxy resin include "jER" (registered trademark) 152 and "jER" (registered trademark) 154 (all manufactured by Mitsubishi Chemical Corporation), "EPICLON" (registered

trademark) 740 (DIC Corporation), and EPN179 and EPN180 (all manufactured by Huntsman Advanced Materials).

Specific examples of the glycidylamine type epoxy resin include tetraglycidyldiaminodiphenylmethanes, glycidyl compounds of aminophenol, glycidylanilines, and glycidyl compounds of xylenediamine.

Commercially available products of tetraglycidyl diaminodiphenylmethanes include "SUMI-EPOXY" (registered trademark) ELM434 (manufactured by Sumitomo Chemical Co., Ltd.), "Araldite" (registered trademark) MY720, "Araldite" (registered trademark) MY721, "Araldite" (registered trademark) MY9512, "Araldite" (registered trademark) MY9612, "Araldite" (registered trademark) MY9634, and "Araldite" (registered trademark) MY9663 (all manufactured by Huntsman Advanced Materials), "jER" (registered trademark) 604 (manufactured by Mitsubishi Chemical Corporation), and "Bakelite" (registered trademark) EPR494, "Bakelite" (registered trademark) EPR495, "Bakelite" (registered trademark) EPR496, and "Bakelite" (registered trademark) EPR497 (all manufactured by Bakelite AG).

Commercially available products of glycidyl compounds of aminophenol include "jER" (registered trademark) 630 (manufactured by Mitsubishi Chemical Corporation), "Araldite" (registered trademark) MY0500 and "Araldite" (registered trademark) MY0510 (all manufactured by Huntsman Advanced Materials), and "SUMI-EPOXY" (registered trademark) ELM120 and "SUMI-EPOXY" (registered trademark) ELM100 (all manufactured by Sumitomo Chemical Co., Ltd.).

Commercially available products of glycidylanilines include GAN and GOT (all manufactured by Nippon Kayaku Co., Ltd.) and "Bakelite" (registered trademark) EPR493 (manufactured by Bakelite AG).

Examples of the glycidyl compounds of xylenediamine include TETRAD-X (registered trademark) (manufactured by MITSUBISHI GAS CHEMICAL COMPANY).

Specific examples of the glycidyl ester type epoxy resin include diglycidyl phthalate, diglycidyl hexahydrophthalate, diglycidyl isophthalate, dimer acid diglycidyl ester, and various isomers of these.

Commercially available products of diglycidyl phthalate include "EPOMIK" (registered trademark) R508 (manufactured by Mitsui Chemicals, Inc.) and "Denacol" (registered trademark) EX-721 (manufactured by Nagase ChemteX Corporation).

Commercially available products of diglycidyl hexahydrophthalate include "EPOMIK" (registered trademark) R540 (manufactured by Mitsui Chemicals, Inc.) and AK-601 (manufactured by Nippon Kayaku Co., Ltd.).

Commercially available products of dimer acid diglycidyl ester include "jER" (registered trademark) 871 (manufactured by Mitsubishi Chemical Corporation) and "Epotohto" (registered trademark) YD-171 (manufactured by NIPPON STEEL Chemical & material Co., Ltd.).

Commercially available products of alicyclic epoxy resin include "CELLOXIDE" (registered trademark) 2021P (manufactured by DAICEL CORPORATION), CY179 (manufactured by Huntsman Advanced Materials), "CELLOXIDE" (registered trademark) 2081 (manufactured by DAICEL CORPORATION), and "CELLOXIDE" (registered trademark) 3000 (manufactured by DAICEL CORPORATION).

As the epoxy resin, biphenyl type epoxy resin, a resin selected from bisphenol A type epoxy resin, bisphenol F type epoxy resin, and bisphenol S type epoxy resin is preferable, biphenyl type epoxy resin and bisphenol A type epoxy resin is more preferable, and biphenyl type epoxy resin is still more preferable from the viewpoint of heat resistance, toughness, and low reflowability. The above epoxy resins may be used singly, or two or more kinds thereof may be used concurrently.

A curing agent and/or a curing accelerator can be added to the epoxy resin composition.

Examples of the epoxy resin curing agent include aliphatic polyamine-based curing agents such as diethylenetriamine and triethylenetetraamine; alicyclic polyamine-based curing agents such as mensendiamine and isophoronediamine; aromatic polyamine-based curing agents such as diaminodiphenylmethane and m-phenylenediamine; acid anhydride-based curing agents such as polyamide, modified polyamine, phthalic anhydride, pyromellitic anhydride, and trimellitic anhydride; polyphenolic curing agents such as phenol novolac resin and phenol aralkyl resin; anionic catalysts such as polymercaptan, 2,4,6-tris(dimethylaminomethyl)phenol, 2-ethyl-4-methylimidazole, and 2-phenyl-4-methylimidazole; cationic catalysts such as boron trifluoride and monoethylamine complexes; latent curing agents such as dicyandiamide, aromatic diazonium salts, and molecular sieves.

A curing agent selected from an aromatic amine-based curing agent, an acid anhydride-based curing agent, and a polyphenolic curing agent is preferably used particularly from the viewpoint of providing a cured epoxy resin exhibiting excellent mechanical properties.

Specific examples of aromatic amine-based curing agent include metaphenylenediamine, diaminodiphenylmethane, diaminodiphenylsulfone, metaxylylenediamine, diphenyl-p-dianiline, and various derivatives such as alkylsubstituted products of these and isomers of these having an amino group at different positions.

Specific examples of the acid anhydride-based curing agent include methyltetrahydrophthalic anhydride, methylhexahydrophthalic anhydride, methyl nadic anhydride, hydrogenated methyl nadic anhydride, trialkyltetrahydrophthalic anhydride, tetrahydrophthalic anhydride, hexahydrophthalic anhydride, dodecenyl succinic anhydride, and benzophenone tetracarboxylic dianhydride.

Specific examples of the polyphenolic curing agent include phenol aralkyl resin, 1-naphthol aralkyl resin, o-cresol novolac epoxy resin, dicyclopentadiene phenol resin, terpene phenol resin, and naphthol novolac type resin.

The optimum value for the amount of curing agent added depends on the epoxy resin and the kind of curing agent, but the stoichiometric equivalent ratio of the curing agent is preferably between 0.5 and 1.4 and more preferably between 0.6 and 1.4 with respect to all epoxy groups contained in the epoxy resin composition. In a case in which the equivalence ratio is lower than 0.5, the curing reaction does not sufficiently occur and curing failure occurs or it takes a long time for the curing reaction in some cases. In a case in which the equivalent ratio is higher than 1.4, the curing agent which is not consumed at the time of curing becomes a defect and this deteriorates the mechanical properties in some cases.

The curing agent can be used in either of a monomer or oligomer form, and may be in either of a powder or liquid form at the time of mixing. These curing agents may be used singly, or two or more kinds thereof may be used concurrently. Moreover, a curing accelerator may be concurrently used.

As the curing accelerator, an amine compound-based curing accelerator typified by 1,8-diazabicyclo(5.4.0)undecene-7; imidazole compound-based curing accelerators typified by 2-methylimidazole and 2-ethyl-4-methylimidazole; phosphorus compound-based curing accelerators typified by triphenyl phosphite; and the like can be used. Among these, phosphorus compound-based curing accelerators are most preferable.

In addition to the epoxy resin and the block copolymer, various additives such as a flame retardant, a filler, a coloring agent, a release agent may be added to the epoxy resin composition of the present invention if necessary.

The filler is not particularly limited, but and powders and fine particles of fused silica, crystalline silica, alumina, zircon, calcium silicate, calcium carbonate, silicon carbide, aluminum nitride, boron nitride, beryllia, zirconia and the like are used. These fillers may be used singly, or two or more kinds thereof may be used concurrently. Among these, it is preferable to use fused silica since the coefficient of linear expansion is lowered. In addition, the shape of the filler is preferably a spherical shape from the viewpoint of fluidity at the time of molding and abrasion property.

The amount of the filler blended is preferably 20 parts by mass to 2000 parts by mass, more preferably 50 to 2000 parts by mass, still more preferably 100 to 2000 parts by mass, particularly preferably 100 to 1000 parts by mass, and most preferably 500 to 800 parts by mass with respect to 100 parts by mass of the epoxy resin from the viewpoint of lowering the coefficient of moisture absorption and the coefficient of linear expansion and improving the strength.

Examples of other additives include carbon black, calcium carbonate, titanium oxide, silica, aluminum hydroxide, a glass fiber, a hindered amine-based degradation inhibitor, and a hindered phenol-based degradation inhibitor.

These additives are preferably added at a stage before the epoxy resin composition is cured, and may be added in any of a powder, liquid, or slurry form.

The epoxy resin composition of the present invention exhibits favorable fluidity and excellent handleability. In a case in which the fluidity is poor, there is a risk that the epoxy resin composition cannot be filled in the fine portions and this causes the formation of voids and the damage to the package when being used in a semiconductor encapsulating material. When the block copolymer of the present invention is added to an epoxy resin, an increase in viscosity due to the addition is minor and an epoxy resin composition exhibiting excellent fluidity can be obtained. Incidentally, two or more kinds of block copolymers may be added to the epoxy resin composition.

The polysiloxane-polyalkylene glycol block copolymer of the present invention has a polysiloxane skeleton which is incompatible with an epoxy resin but exhibits excellent flexibility and a polyalkylene glycol skeleton which is compatible with an epoxy resin and exhibits excellent flexibility, and thus, the polysiloxane-polyalkylene glycol block copolymer exhibits both good dispersibility in a cured epoxy resin and an effect of lowering the modulus of elasticity. A cured epoxy resin can be produced by a known method. Examples thereof include a method in which an epoxy resin, a curing agent, a curing accelerator, and various additives, and a filler are mixed and cured by heating in the production.

The fluidity of the epoxy resin composition in production of a cured product is preferably low from the viewpoint of work efficiency during production of an encapsulating material. Impurities contained in the block copolymer increase the viscosity of the epoxy resin composition and decreases the fluidity in some cases. Such impurities, if any, are preferably subjected to purification and drying so as to be reduced within a range which causes no decrease in fluidity. In particular, impurities having a nitrogen atom cause a decrease in fluidity, and examples of such impurities include amines.

The fluidity of the epoxy resin composition can be evaluated by measuring the viscosity using a rheometer. Specifically, the viscosity at a temperature of 200°C of an epoxy resin composition containing 15 parts by mass of the polysiloxane-polyalkylene glycol block copolymer with respect to 100 parts by mass of the epoxy resin is measured using a rheometer. Incidentally, in the case of containing an epoxy resin curing agent, the viscosity of the epoxy resin composition containing the polysiloxane-polyalkylene glycol block copolymer at 15 parts by mass with respect to 100 parts by mass of the sum of the epoxy resin and the epoxy resin curing agent is measured. In the same manner, the viscosity at a temperature of 200°C of an epoxy resin not containing the block copolymer is measured. The thus measured viscosities at 200°C are used to evaluate the fluidity in accordance with the proportion of increase in the viscosity of an epoxy resin composition containing 15 parts by mass of the block copolymer with respect to 100 parts by mass of the epoxy resin composition with respect to the viscosity of the epoxy resin not containing the block copolymer. The proportion of increase in the viscosity is preferably 15 times or less, more preferably 10 times or less, particularly preferably 8 times

or less, and most preferably 5 times or less. The smaller the proportion of increase in the viscosity, the more preferable. The lower limit of the viscosity is theoretically 1 time or more. It is not preferable that the proportion of increase in the viscosity is great since the fluidity of the epoxy resin composition to be obtained is deteriorated, the epoxy resin composition cannot penetrate into the fine portions at the time of molding of the encapsulating material, and cracking is caused.

The epoxy resin composition of the present invention can be produced by adding the block copolymer to an epoxy resin and, if necessary, a curing agent and kneading the mixture using a generally known kneader. Examples of the kneader include a three-roll kneader, a rotary and revolutionary mixer, and a planetary mixer.

The cured epoxy resin of the present invention is obtained by curing the epoxy resin composition described above.

In order to advance the curing reaction for obtaining the cured epoxy resin, the temperature may be adjusted if necessary. The temperature at that time is preferably room temperature to 250°C, more preferably 50°C to 200°C, still more preferably 70°C to 190°C, and particularly preferably 100°C to 180°C. Moreover, the temperature raising program may be applied if necessary. In this case, the rate of temperature rise is not particularly limited but is preferably 0.5 to 20°C/min, more preferably 0.5 to 10°C/min, and still more preferably 1 to 5°C/min.

Moreover, the pressure at the time of curing is preferably 1 to 100 kg/cm$^2$, more preferably 1 to 50 kg/cm$^2$, still more preferably 1 to 20 kg/cm$^2$, and particularly preferably 1 to 5 kg/cm$^2$.

The polysiloxane-polyalkylene glycol block copolymer of the present invention can be well dispersed in a cured epoxy resin. Whether or not the block copolymer is well dispersed can be judged by staining the resin plate after curing with ruthenium tetroxide and confirming the cross section thereof using a photograph observed through a transmission electron microscope. The polysiloxane domain is stained in the staining with ruthenium tetroxide. The finer the average domain diameter of polysiloxane domain, the better the dispersibility, and thus, the more preferable. The average domain diameter of polysiloxane domain can be calculated by specifying the diameters of 100 arbitrary domains from the above photograph taken by a transmission electron microscope (TEM) and determining the arithmetic average according to the following equation. The maximum diameter of domain is taken as the diameter in a case in which the domain does not have a perfect spherical shape.

[Math. 2]

$$Dn = \left(\sum_{i=1}^{n} R_i\right)/n$$

In the equation, Ri denotes the diameter of an individual domain, n denotes the number of measurements 100, and Dn denotes the average domain diameter.

The average domain diameter of polysiloxane domain in a cured epoxy resin which is determined by the present method is preferably 50 μm or less, more preferably 10 μm or less, still more preferably 5 μm or less, particularly preferably 3 μm or less, remarkably preferably 1 μm or less, and most preferably 500 nm or less.

In a case in which the measurement in a dispersed state by the above-described method is difficult, the dispersed state of the polysiloxane-polyalkylene glycol block copolymer in the cured epoxy resin can be confirmed by energy dispersive X-ray analysis (EDX). Specifically, the cross section of the cured epoxy resin to which polysiloxane is added is observed by EDX, and mapping with silicon is performed to judge the dispersed state of the polysiloxane-polyalkylene glycol block copolymer.

The semiconductor encapsulating material of the present invention is composed of the cured epoxy resin of the present invention. The cured epoxy resin of the present invention is used as a material suitable for a semiconductor encapsulating material since the polysiloxane-polyalkylene glycol block copolymer functions as a stress relief agent. The semiconductor encapsulating material mentioned here refers to a material for encapsulating electronic parts such as semiconductor elements so as to protect these from external stimuli.

As described above, the polysiloxane-polyalkylene glycol block copolymer of the present invention is obtained by a reaction of the polysiloxane (A) having a functional group with the polyalkylene glycol (B) having a functional group and exhibits extremely excellent dispersibility in an epoxy resin since a great number of functional groups can exist in the molecule even when being prepared to have a high molecular weight. Moreover, reacting the carboxyl group of the thus obtained block copolymer intermediate with a compound reactive with a carboxyl group to regulate the carboxyl group content to a desired value makes it possible that adding the copolymer to an epoxy resin results in allowing the cured product to express a marked effect of lowering the modulus of elasticity. The epoxy resin composition containing the polysiloxane-polyalkylene glycol block copolymer of the present invention and an epoxy resin exhibits excellent fluidity, has a minor decrease in fluidity due to the addition of the block copolymer, and exhibits excellent handleability. Furthermore, in the cured epoxy resin obtained by curing this epoxy resin composition, the block copolymer added is

finely dispersed, bleed-out is also suppressed, and not only an effect on lowering the modulus of elasticity of the cured epoxy resin but also an effect on improving the toughness of the cured epoxy resin are exerted. From these facts, the block copolymer of the present invention is extremely useful as a stress relief agent for epoxy resins.

Examples

Next, the present invention will be described in more detail with reference to Examples. The present invention is not limited to these Examples. In Examples, the measurement methods used are as follows.

(1) Measurement of weight average molecular weight

The weight average molecular weights of the polysiloxane-polyalkylene glycol block copolymer, the polysiloxane (A) having a functional group, and the polyalkylene glycol (B) having a functional group were calculated by measuring the molecular weights by gel permeation chromatography under the following conditions and comparing the results with the calibration curves attained using polymethyl methacrylate.
Apparatus: LC-20AD Series manufactured by Shimadzu Corporation
Column: KF-806L × 2 manufactured by Showa Denko K.K.
Flow rate: 1.0 mL/min
Mobile phase: tetrahydrofuran
Detection: differential refractometer
Column temperature: 40°C.

(2) Quantification of carboxyl group content

In 10 g of tetrahydrofuran, 0.5 g of a polysiloxane-polyalkylene glycol block copolymer was dissolved, and titration was conducted with 0.1 mol/L alcoholic potassium hydroxide using phenolphthalein as an indicator to quantify the carboxyl group content.

(3) Method for calculating the content of a structure derived from polysiloxane (A)

The content of the polysiloxane-derived structure in the polysiloxane-polyalkylene glycol block copolymer was determined by dividing the weight of the polysiloxane (A) having a functional group by the total weight of all raw materials in synthesis of the block copolymer. Incidentally, in a case in which the reaction between the block copolymer intermediate and a compound reactive with a carboxyl group generated a byproduct, the weight of the byproduct was subtracted from the total weight of all raw materials in the calculation. That is, the content of a structure derived from the polysiloxane (A) was calculated by the following equation.

[Math. 3]

$$\text{Content of structure derived from polysiloxane (A) (\% by mass)} = \frac{\textit{Weight of polysiloxane (A)}}{\textit{Weight of all raw materials - weight of byproduct}} \times 100$$

(4) Measurement of viscosity

The viscosity of an epoxy resin presented in each Example was measured under the following conditions using a rheometer (MCR501 manufactured by Anton Paar GmbH), and the viscosity at 200°C was determined. Next, the viscosity at 200°C of an epoxy resin composition in which a block copolymer was added at 15 parts by mass with respect to 100 parts by mass of the sum of the same epoxy resin and epoxy resin curing agent was measured in the same manner. The fluidity was evaluated from the magnification of the proportion of increase in the viscosity of the epoxy resin composition containing at 15 parts by mass of the block copolymer with respect to the viscosity of the epoxy resin not containing the block copolymer.

Jig: φ25 mm parallel plate
Frequency: 0.5 Hz
Strain: 100%

Gap: 1 mm
Measurement temperature: 70°C to 220°C
Rate of temperature rise: 10°C/min
Atmosphere: nitrogen.

(5) Measurement of bending modulus of elasticity and strain at break

A cured epoxy resin in which a polysiloxane-polyalkylene glycol block copolymer was dispersed was cut to have a width of 10 mm, a length of 80 mm, and a thickness of 4 mm, thereby obtaining a test piece. A three-point bending test was performed at a distance between fulcrums of 64 mm and a test speed of 2 mm/min in conformity with JIS K7171 (2008) using TENSILON universal testing machine (TENSIRON TRG-1250 manufactured by A & D Company, Limited), and the bending modulus of elasticity and the strain at break were measured. The measurement temperature was set to room temperature (23°C), the number of measurements was set to n = 5, and the average value thereof was determined.

(6) Measurement of average domain diameter of polysiloxane domain in cured product

A cured epoxy resin in which a polysiloxane-polyalkylene glycol block copolymer was dispersed was stained with ruthenium tetroxide, and the diameters of 100 arbitrary polysiloxane domains were measured from a photograph of the cross section taken by a transmission electron microscope and calculated according to the following equation.

[Math. 4]

$$Dn = \left(\sum_{i=1}^{n} R_i\right)/n$$

In the equation, Ri denotes the diameter of an individual domain, n denotes the number of measurements 100, and Dn denotes the average domain diameter.

(Synthesis of polysiloxane-polyalkylene glycol block copolymer intermediate)

[Synthesis Example 1]

Into a 100 mL separable flask, 10.0 g of silicone oil having both ends modified with maleic anhydride (manufactured by Shin-Etsu Chemical Co., Ltd., X-22-168AS, weight average molecular weight: 1300, 5% weight loss temperature: 299°C) and 10.0 g of polytetramethylene glycol (manufactured by Wako Pure Chemical Industries, Ltd., polytetramethylene oxide 1,000, weight average molecular weight: 2700, 5% weight loss temperature: 275°C) were added, and nitrogen purging was conducted. Thereafter, the mixture was heated to 120°C and reacted for 8 hours, and a polysiloxane-polyalkylene glycol block copolymer intermediate was obtained. The obtained polysiloxane-polyalkylene glycol block copolymer intermediate had a polysiloxane (A)-derived structure content of 50% by mass, a carboxyl group content of 1.01 mmol/g, a number average molecular weight of 27,800, and a weight average molecular weight of 49,200. The results are presented in Table 1.

[Synthesis Example 2]

Into a 100 mL separable flask, 10 g of silicone oil having both ends modified with a hydroxyl group (manufactured by Shin-Etsu Chemical Co., Ltd., KF-6001, weight average molecular weight: 3000, 5% weight loss temperature: 298°C) and 8.0 g of polypropylene glycol (manufactured by Wako Pure Chemical Industries, Ltd., polypropylene glycol, diol type, 2000, weight average molecular weight: 3350, 5% weight loss temperature: 296°C) were added to obtain a uniform solution. Next, 2.0 g of pyromellitic dianhydride (manufactured by Tokyo Chemical Industry Co., Ltd.) was added to the uniform solution, and nitrogen purging was conducted. Thereafter, the mixture was heated to 160°C and reacted for 8 hours, and a polysiloxane-polyalkylene glycol block copolymer intermediate was obtained. The obtained polysiloxane-polyalkylene glycol block copolymer intermediate had a polysiloxane (A)-derived structure content of 50% by mass, a carboxyl group content of 0.95 mmol/g, a number average molecular weight of 14,300, and a weight average molecular weight of 32,000. The results are presented in Table 1.

[Synthesis Example 3]

Into a 100 mL two-necked flask, 10.0 g of silicone oil having both ends modified with maleic anhydride (manufactured by Shin-Etsu Chemical Co., Ltd., X-22-168AS, weight average molecular weight: 1300, 5% weight loss temperature: 299°C), 6.5 g of polytetramethylene glycol (manufactured by Wako Pure Chemical Industries, Ltd., polytetramethylene oxide 650, weight average molecular weight: 1600, 5% weight loss temperature: 263°C), and 66 g of toluene were added, and nitrogen purging was conducted. Thereafter, the mixture was heated to 120°C and reacted for 8 hours, and a colorless and transparent liquid was obtained. Toluene was removed from the liquid using an evaporator, and then the resultant was dried in a vacuum dryer at 80°C for 18 hours to completely remove toluene. The obtained polysiloxane-polyalkylene glycol block copolymer intermediate was a colorless and transparent liquid, and had a polysiloxane (A)-derived structure content of 61% by mass, a carboxyl group content of 0.68 mmol/g, a number average molecular weight of 27,000, and a weight average molecular weight of 49,000. The results are presented in Table 1.

[Synthesis Example 4]

Into a 100 mL separable flask, 10.0 g of silicone oil having both ends modified with maleic anhydride (manufactured by Shin-Etsu Chemical Co., Ltd., X-22-168AS, weight average molecular weight: 1300, 5% weight loss temperature: 299°C) and 10.0 g of polytetramethylene glycol (manufactured by Wako Pure Chemical Industries, Ltd., polytetramethylene oxide 1,000, weight average molecular weight: 2700, 5% weight loss temperature: 275°C) were added, and nitrogen purging was conducted. Thereafter, the mixture was heated to 120°C and reacted for 0.5 hours, and a polysiloxane-polyalkylene glycol block copolymer intermediate was obtained. The obtained polysiloxane-polyalkylene glycol block copolymer intermediate had a polysiloxane (A)-derived structure content of 50% by mass, a carboxyl group content of 1.00 mmol/g, a number average molecular weight of 4,400, and a weight average molecular weight of 8,900. The results are presented in Table 1.

[Synthesis Example 5]

Into a 100 mL separable flask, 10.0 g of silicone oil having both ends modified with an amino group (manufactured by Shin-Etsu Chemical Co., Ltd., KF-8010, weight average molecular weight: 1200, 5% weight loss temperature: 295°C), 10.0 g of polytetramethylene glycol (manufactured by Wako Pure Chemical Industries, Ltd., polytetramethylene oxide 1,000, weight average molecular weight: 2700, 5% weight loss temperature: 275°C), and 3.8 g of pyromellitic anhydride (manufactured by Tokyo Chemical Industry Co., Ltd.) were added, and nitrogen purging was conducted. Thereafter, the mixture was heated to 100°C and reacted for 8 hours, and a polysiloxane-polyalkylene glycol block copolymer intermediate was obtained. The obtained polysiloxane-polyalkylene glycol block copolymer intermediate had a polysiloxane (A)-derived structure content of 50% by mass, a carboxyl group content of 0.95 mmol/g, a number average molecular weight of 12,200, and a weight average molecular weight of 25,000. The results are presented in Table 1.

[Production Example 1]

Into a 100 mL separable flask, 15 g of the polysiloxane-polyalkylene glycol block copolymer intermediate synthesized in Synthesis Example 1 and 0.85 g of triethyl orthoacetate were added, nitrogen purging was conducted, and the resulting mixture was heated to 70°C and allowed to react for 6 hours. Thereafter, the mixture was dried in vacuo at 80°C for 12 hours to remove byproducts, and a polysiloxane-polyalkylene glycol block copolymer was thus obtained. The obtained polysiloxane-polyalkylene glycol block copolymer had a polysiloxane (A)-derived structure content of 50% by mass, a carboxyl group content of 0.66 mmol/g, a number average molecular weight of 38,600, and a weight average molecular weight of 112,900. The results are presented in Table 1.

[Production Example 2]

Into a 100 mL separable flask, 15 g of the polysiloxane-polyalkylene glycol block copolymer intermediate synthesized in Synthesis Example 2 and 0.51 g of triethyl orthoacetate were added, nitrogen purging was conducted, and the resulting mixture was heated to 70°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 50% by mass, a carboxyl group content of 0.74 mmol/g, a number average molecular weight of 19,000, and a weight average molecular weight of 50,200. The results are presented in Table 1.

[Production Example 3]

Into a 100 mL separable flask, 15 g of the polysiloxane-polyalkylene glycol block copolymer intermediate synthesized in Synthesis Example 2 and 0.78 g of triethyl orthoacetate were added, nitrogen purging was conducted, and the resulting mixture was heated to 70°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane had a polysiloxane (A)-derived structure content of 50% by mass, a carboxyl group content of 0.63 mmol/g, a number average molecular weight of 18,600, and a weight average molecular weight of 47,400. The results are presented in Table 1.

[Production Example 4]

Into a 100 mL separable flask, 15 g of the polysiloxane-polyalkylene glycol block copolymer intermediate synthesized in Synthesis Example 2 and 1.11 g of triethyl orthoacetate were added, nitrogen purging was conducted, and the resulting mixture was heated to 70°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 49% by mass, a carboxyl group content of 0.49 mmol/g, a number average molecular weight of 17,000, and a weight average molecular weight of 41,700. The results are presented in Table 1.

[Production Example 5]

Into a 100 mL separable flask, 15 g of the polysiloxane-polyalkylene glycol block copolymer intermediate synthesized in Synthesis Example 2 and 1.39 g of triethyl orthoacetate were added, nitrogen purging was conducted, and the resulting mixture was heated to 70°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 49% by mass, a carboxyl group content of 0.38 mmol/g, a number average molecular weight of 17,000, and a weight average molecular weight of 43,300. The results are presented in Table 1.

[Production Example 6]

Into a 100 mL separable flask, 15 g of the polysiloxane-polyalkylene glycol block copolymer intermediate synthesized in Synthesis Example 2 and 0.72 g of trimethyl orthoacetate were added, nitrogen purging was conducted, and the resulting mixture was heated to 70°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 50% by mass, a carboxyl group content of 0.55 mmol/g, a number average molecular weight of 14,900, and a weight average molecular weight of 37,200. The results are presented in Table 1.

[Production Example 7]

Into a 100 mL separable flask, 15 g of the polysiloxane-polyalkylene glycol block copolymer intermediate synthesized in Synthesis Example 2 and 1.00 g of 2-ethyl-2-oxazoline were added, nitrogen purging was conducted, the resulting mixture was heated to 100°C and allowed to react for 5 hours, and a polysiloxane-polyalkylene glycol block copolymer was obtained. The obtained polysiloxane-polyalkylene glycol block copolymer had a polysiloxane (A)-derived structure content of 47% by mass, a carboxyl group content of 0.30 mmol/g, a number average molecular weight of 8,800, and a weight average molecular weight of 17,700. The results are presented in Table 1.

[Production Example 8]

Into a 100 mL separable flask, 15 g of the polysiloxane-polyalkylene glycol block copolymer intermediate synthesized in Synthesis Example 2 and 1.12 g of N,N-dimethylformamide dimethylacetal were added, nitrogen purging was conducted, and the resulting mixture was heated to 50°C and allowed to react for 5 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 50% by mass, a carboxyl group content of 0.32 mmol/g, a number average molecular weight of 10,500, and a weight average molecular weight of 21,900. The results are presented in Table 1.

[Production Example 9]

Into a 100 mL separable flask, 15 g of the polysiloxane-polyalkylene glycol block copolymer intermediate synthesized in Synthesis Example 2 and 0.85 g of phenyl glycidyl ether were added, nitrogen purging was conducted, the resulting mixture was heated to 120°C and allowed to react for 6 hours, and a polysiloxane-polyalkylene glycol block copolymer was obtained. The obtained polysiloxane-polyalkylene glycol block copolymer had a polysiloxane (A)-derived structure content of 50% by mass, a carboxyl group content of 0.73 mmol/g, a number average molecular weight of 13,800, and a weight average molecular weight of 39,500. The results are presented in Table 1.

[Production Example 10]

Into a 100 mL separable flask, 15 g of the polysiloxane-polyalkylene glycol block copolymer intermediate synthesized in Synthesis Example 4 and 1.00 g of triethyl orthoacetate were added, nitrogen purging was conducted, and the resulting mixture was heated to 50°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 50% by mass, a carboxyl group content of 0.51 mmol/g, a number average molecular weight of 4,400, and a weight average molecular weight of 9,000. The results are presented in Table 1.

[Production Example 11]

Into a 100 mL separable flask, 15 g of the polysiloxane-polyalkylene glycol block copolymer intermediate synthesized in Synthesis Example 5 and 0.85 g of triethyl orthoacetate were added, nitrogen purging was conducted, and the resulting mixture was heated to 70°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 50% by mass, a carboxyl group content of 0.70 mmol/g, a number average molecular weight of 30,500, and a weight average molecular weight of 102,900. The results are presented in Table 1.

[Reference Example 1]

Into a 100 mL separable flask, 15 g of the polysiloxane-polyalkylene glycol block copolymer intermediate synthesized in Synthesis Example 2 and 2.16 g of triethyl orthoacetate were added, nitrogen purging was conducted, and the resulting mixture was heated to 70°C and allowed to react for 6 hours. Thereafter, the mixture was dried in vacuo at 80°C for 12 hours to remove the byproduct, and a polysiloxane-polyalkylene glycol block copolymer was obtained. The obtained polysiloxane-polyalkylene glycol block copolymer had a polysiloxane (A)-derived structure content of 49% by mass, a carboxyl group content of 0.06 mmol/g, a number average molecular weight of 19,400, and a weight average molecular weight of 54,700. The results are presented in Table 1.

[Table 1]

| | Polysiloxane(A) | Polyalkylene glycol (B) | Copolymerization component (C) | Compound reactive with caiboxyl group | Content of structure derived from polysiloxane (A) in block copolymer (% by mass) | Content of functional group in block copolymer (mmol/g) |
|---|---|---|---|---|---|---|
| Synthesis Example 1 | Silicone oil having both ends modified with maleic anhydride | Polytetramethylene glycol | - | - | 50 | 1.01 |
| Synthesis Example 2 | Silicone oil having both ends modified with hydroxyl group | Polypropylene glycol | Pyromellitic dianhydride | - | 50 | 0.95 |
| Synthesis Example 3 | Silicone oil having both ends modified with maleic anhydride | Polytetramethylene glycol | - | - | 61 | 0.68 |
| Synthesis Example 4 | Silicone oil having both ends modified with maleic anhydride | Polytetramethylene glycol | - | - | 50 | 1.00 |
| Synthesis Example 5 | Silicone oil having both ends modified with amino group | Polytetramethylene glycol | Pyromellitic dianhydride | - | 50 | 1.00 |
| Production Example 1 | Silicone oil having both ends modified with maleic anhydride | Polytetramethylene glycol | - | Triethyl orthoacetate | 50 | 0.66 |
| Production Example 2 | Silicone oil having both ends modified with hydroxyl group | Polypropylene glycol | Pyromellitic dianhydride | Triethyl orthoacetate | 50 | 0.74 |
| Production Example 3 | Silicone oil having both ends modified with hydroxyl group | Polypropylene glycol | Pyromellitic dianhydride | Triethyl orthoacetate | 50 | 0.63 |
| Production Example 4 | Silicone oil having both ends modified with hydroxyl group | Polypropylene glycol | Pyromellitic dianhydride | Triethyl orthoacetate | 49 | 0.49 |
| Production Example 5 | Silicone oil having both ends modified with hydroxyl group | Polypropylene glycol | Pyromellitic dianhydride | Triethyl orthoacetate | 49 | 0.38 |

(continued)

[Table 1]

| | Polysiloxane(A) | Polyalkylene glycol (B) | Copolymerization component (C) | Compound reactive with caiboxyl group | Content of structure derived from polysiloxane (A) in block copolymer (% by mass) | Content of functional group in block copolymer (mmol/g) |
|---|---|---|---|---|---|---|
| Production Example 6 | Silicone oil having both ends modified with hydroxyl group | Polypropylene glycol | Pyromellitic dianhydride | Trimethyl orthoacetate | 50 | 0.55 |
| Production | Silicone oil having both ends | Polypropylene glycol | Pyromellitic | 2-ethyl-2-oxazoline | 47 | 0.30 |
| Example 7 | modified with hydroxyl group | | dianhydride | | | |
| Production Example 8 | Silicone oil having both ends modified with hydroxyl group | Polypropylene glycol | Pyromellitic dianhydride | *N,N*-dimethylformamide dimethylacetal | 50 | 0.32 |
| Production Example 9 | Silicone oil having both ends modified with hydroxyl group | Polypropylene glycol | Pyromellitic dianhydride | Phenyl glycidyl ether | 50 | 0.73 |
| Production Example 10 | Silicone oil having both ends modified with maleic anhydride | Polytetramethylene glycol | Pyromellitic dianhydride | Triethyl orthoacetate | 50 | 0.51 |
| Production Example 11 | Silicone oil having both ends modified with amino group | Polytetramethylene glycol | Pyromellitic dianhydride | Triethyl orthoacetate | 50 | 0.70 |
| Reference Example 1 | Silicone oil having both ends modified with hydroxyl group | Polypropylene glycol | Pyromellitic dianhydride | Triethyl orthoacetate | 49 | 0.06 |

[Example 1]

In a 150 cc stainless steel beaker, 9.0 g of the polysiloxane-polyalkylene glycol block copolymer obtained in Production Example 2, 38.25 g of biphenyl type epoxy resin (manufactured by Mitsubishi Chemical Corporation, "jER" (registered trademark) YX4000H) as an epoxy resin, and 21.75 g of phenol novolac type curing agent (manufactured by MEIWA PLASTIC INDUSTRIES, LTD., H-1) as a curing agent were weighed, dissolved using an oven at 120°C, and uniformly mixed. Then, 0.3 g of tetraphenylphosphonium tetra-p-tolylborate as a curing accelerator was added thereto, and the mixture was simply mixed using a stirring bar, and then mixing at 2000 rpm and 80 kPa for 1.5 minutes was conducted one time, stirring at 2000 rpm and 50 kPa for 1.5 minutes was conducted one time, and stirring at 2000 rpm and 0.2 kPa for 1.5 minutes was conducted two times using a rotary and revolutionary mixer "Awatori Rentaro" (manufactured by THINKY CORPORATION), thereby obtaining an uncured epoxy resin composition.
This uncured epoxy resin composition was cast into an aluminum mold in which a 4 mm-thick "Teflon" (registered trademark) spacer and a release film were set, and the mold was placed in an oven. The oven temperature was set to 80°C and maintained for 5 minutes, then the temperature was raised to 175°C at a rate of temperature rise of 1.5°C/min, and curing was conducted for 4 hours, thereby obtaining a cured epoxy resin having a thickness of 4 mm.
The cured epoxy resin obtained was cut to have a width of 10 mm and a length of 80 mm, the bending modulus of elasticity and the strain at break were measured by the above-mentioned method, and as a result, the bending modulus of elasticity was 2.1 GPa and the strain at break was 15%. The average domain diameter of the polysiloxane in the cured epoxy resin was 130 nm (Fig. 1).
The viscosity of the epoxy resin composition at 200°C was 0.10 Pa·s, the proportion of increase in the viscosity with respect to the viscosity of the epoxy resin not containing the block copolymer was 2.5 times, and thus, the fluidity was good. The results presented a low modulus of elasticity, good dispersibility, and also excellent fluidity. The results are presented in Table 2.

[Example 2]

A cured epoxy resin was obtained in the same manner as in Example 1 except that the copolymer was replaced with 9.0 g of the polysiloxane-polyalkylene glycol block copolymer obtained in Production Example 3. The bending modulus of elasticity and the strain at break of the cured epoxy resin obtained were measured, as a result, the bending modulus of elasticity was 1.8 GPa and the strain at break was 14%. The average domain diameter of the polysiloxane in the cured epoxy resin was 3100 nm (Fig. 2).
The viscosity of the epoxy resin composition at 200°C was 0.11 Pa·s, the proportion of increase in the viscosity with respect to the viscosity of the epoxy resin not containing the block copolymer was 2.8 times, and thus, the fluidity was good. The results presented a low modulus of elasticity, good dispersibility, and also excellent fluidity. The results are presented in Table 2.

[Example 3]

A cured epoxy resin was obtained in the same manner as in Example 1 except that the copolymer was replaced with 9.0 g of the polysiloxane-polyalkylene glycol block copolymer obtained in Production Example 5. The bending modulus of elasticity and the strain at break of the cured epoxy resin obtained were measured, as a result, the bending modulus of elasticity was 1.5 GPa and the strain at break was 7.2%. The average domain diameter of the polysiloxane in the cured epoxy resin was 34700 nm.
The viscosity of the epoxy resin composition at 200°C was 0.08 Pa s, the proportion of increase in the viscosity with respect to the viscosity of the epoxy resin not containing the block copolymer was 2.0 times, and thus, the fluidity was good. The results presented a low modulus of elasticity, good dispersibility, and also excellent fluidity. The results are presented in Table 2.

[Example 4]

A cured epoxy resin was obtained in the same manner as in Example 1 except that the copolymer was replaced with 9.0 g of the polysiloxane-polyalkylene glycol block copolymer obtained in Production Example 6. The bending modulus of elasticity and the strain at break of the cured epoxy resin obtained were measured, as a result, the bending modulus of elasticity was 1.9 GPa and the strain at break was 15%. The average domain diameter of the polysiloxane in the cured epoxy resin was 430 nm.
The viscosity of the epoxy resin composition at 200°C was 0.07 Pa s, the proportion of increase in the viscosity with respect to the viscosity of the epoxy resin not containing the block copolymer was 1.8 times, and thus, the fluidity was good. The results presented a low modulus of elasticity, good dispersibility, and also excellent fluidity. The results

are presented in Table 2.

[Example 5]

A cured epoxy resin was obtained in the same manner as in Example 1 except that the copolymer was replaced with 9.0 g of the polysiloxane-polyalkylene glycol block copolymer obtained in Production Example 7. The bending modulus of elasticity and the strain at break of the cured epoxy resin obtained were measured, as a result, the bending modulus of elasticity was 2.2 GPa and the strain at break was 17%. The average domain diameter of the polysiloxane in the cured epoxy resin was 880 nm.
The viscosity of the epoxy resin composition at 200°C was 0.08 Pa s, the proportion of increase in the viscosity with respect to the viscosity of the epoxy resin not containing the block copolymer was 2.0 times, and thus, the fluidity was good. The results presented a low modulus of elasticity, good dispersibility, and also excellent fluidity. The results are presented in Table 2.

[Example 6]

A cured epoxy resin was obtained in the same manner as in Example 1 except that the copolymer was replaced with 4.5 g of the polysiloxane-polyalkylene glycol block copolymer obtained in Production Example 4 and 4.5 g of the polysiloxane-polyalkylene glycol block copolymer obtained in Production Example 7. The bending modulus of elasticity and the strain at break of the cured epoxy resin obtained were measured, as a result, the bending modulus of elasticity was 2.1 GPa and the strain at break was 15%. The average domain diameter of the polysiloxane in the cured epoxy resin was 2010 nm.
The viscosity of the epoxy resin composition at 200°C was 0.07 Pa s, the proportion of increase in the viscosity with respect to the viscosity of the epoxy resin not containing the block copolymer was 1.8 times, and thus, the fluidity was good. The results presented a low modulus of elasticity, good dispersibility, and also excellent fluidity. The results are presented in Table 2.

[Example 7]

A cured epoxy resin was obtained in the same manner as in Example 1 except that the copolymer was replaced with 9.0 g of the polysiloxane-polyalkylene glycol block copolymer obtained in Production Example 8. The bending modulus of elasticity and the strain at break of the cured epoxy resin obtained were measured, as a result, the bending modulus of elasticity was 1.9 GPa and the strain at break was 14%. The average domain diameter of the polysiloxane in the cured epoxy resin was 2050 nm.
The viscosity of the epoxy resin composition at 200°C was 7750 Pa·s, the proportion of increase in the viscosity with respect to the viscosity of the epoxy resin not containing the block copolymer was 200,000 times, and thus, the fluidity was poor. The results presented a low modulus of elasticity and good dispersibility but poor fluidity. The results are presented in Table 2.

[Example 8]

A cured epoxy resin was obtained in the same manner as in Example 1 except that the copolymer was replaced with the polysiloxane-polyalkylene glycol block copolymer obtained in Production Example 9. The bending modulus of elasticity and the strain at break of the cured epoxy resin obtained were measured, as a result, the bending modulus of elasticity was 2.1 GPa and the strain at break was 11%. The average domain diameter of the polysiloxane in the cured epoxy resin was 180 nm.
The viscosity of the epoxy resin composition at 200°C was 0.09 Pa s, the proportion of increase in the viscosity with respect to the viscosity of the epoxy resin not containing the block copolymer was 2.3 times, and thus, the fluidity was good. The results presented a low modulus of elasticity, good dispersibility, and also excellent fluidity. The results are presented in Table 2.

[Example 9]

A cured epoxy resin was obtained in the same manner as in Example 1 except that the copolymer was replaced with the polysiloxane-polyalkylene glycol block copolymer obtained in Production Example 10. The bending modulus of elasticity and the strain at break of the cured epoxy resin obtained were measured, as a result, the bending modulus of elasticity was 2.1 GPa and the strain at break was 12%. The average domain diameter of the polysiloxane in the cured epoxy resin was 1500 nm.

The viscosity of the epoxy resin composition at 200°C was 0.06 Pa s, the proportion of increase in the viscosity with respect to the viscosity of the epoxy resin not containing the block copolymer was 1.5 times, and thus, the fluidity was good. The results presented a low modulus of elasticity, good dispersibility, and also excellent fluidity. The results are presented in Table 2.

[Example 10]

A cured epoxy resin was obtained in the same manner as in Example 1 except that the copolymer was replaced with the polysiloxane-polyalkylene glycol block copolymer obtained in Production Example 11. The bending modulus of elasticity and the strain at break of the cured epoxy resin obtained were measured, as a result, the bending modulus of elasticity was 2.0 GPa and the strain at break was 15%. The average domain diameter of the polysiloxane in the cured epoxy resin was 140 nm.

The viscosity of the epoxy resin composition at 200°C was 0.12 Pa s, the proportion of increase in the viscosity with respect to the viscosity of the epoxy resin not containing the block copolymer was 3.0 times, and thus, the fluidity was good. The results presented a low modulus of elasticity, good dispersibility, and also excellent fluidity. The results are presented in Table 2.

[Comparative Example 1]

A cured epoxy resin was produced in the same manner as in Example 1 except that a polysiloxane-polyalkylene glycol block copolymer was not blended. A three-point bending test was conducted using the cured epoxy resin obtained, as a result, the bending modulus of elasticity was 2.9 GPa and the strain at break was 9.5%. The viscosity of the epoxy resin composition at 200°C was 0.04 Pa·s. The results are presented in Table 2.

[Comparative Example 2]

A cured epoxy resin was obtained in the same manner as in Example 1 except that the copolymer was replaced with 9.0 g of the polysiloxane-polyalkylene glycol block copolymer intermediate synthesized in Synthesis Example 1. The bending modulus of elasticity and the strain at break of the cured epoxy resin obtained were measured, as a result, the bending modulus of elasticity was 2.5 GPa and the strain at break was 11%. The average domain diameter of the polysiloxane in the cured epoxy resin was 53 nm.

The viscosity of the epoxy resin composition at 200°C was 0.11 Pa·s, the proportion of increase in the viscosity with respect to the viscosity of the epoxy resin not containing the block copolymer was 2.8 times, and thus, the fluidity was good. The results presented good dispersibility in the cured epoxy resin and also excellent fluidity but a low effect of lowering the modulus of elasticity. The results are presented in Table 2.

[Comparative Example 3]

A cured epoxy resin was obtained in the same manner as in Example 1 except that the copolymer was replaced with 9.0 g of the polysiloxane-polyalkylene glycol block copolymer intermediate synthesized in Synthesis Example 2. The bending modulus of elasticity and the strain at break of the cured epoxy resin obtained were measured, as a result, the bending modulus of elasticity was 2.3 GPa and the strain at break was 10%. The average domain diameter of the polysiloxane in the cured epoxy resin was 51 nm.

The viscosity of the epoxy resin composition at 200°C was 0.09 Pa s, the proportion of increase in the viscosity with respect to the viscosity of the epoxy resin not containing the block copolymer was 2.3 times, and thus, the fluidity was good. The results presented good dispersibility in the cured epoxy resin and also excellent fluidity but a low effect of lowering the modulus of elasticity. The results are presented in Table 2.

[Comparative Example 4]

A cured epoxy resin was obtained in the same manner as in Example 1 except that the copolymer was replaced with 9.0 g of the polysiloxane-polyalkylene glycol block copolymer intermediate obtained in Synthesis Example 3. The bending modulus of elasticity and the strain at break of the cured epoxy resin obtained were measured, as a result, the bending modulus of elasticity was 2.4 GPa and the strain at break was 11%. The average domain diameter of the polysiloxane in the cured epoxy resin was 65 nm.

The viscosity of the epoxy resin composition at 200°C was 0.10 Pa s, the proportion of increase in the viscosity with respect to the viscosity of the epoxy resin not containing the block copolymer was 2.5 times, and thus, the fluidity was good. The results presented good dispersibility in the cured epoxy resin and also excellent fluidity but a low effect

of lowering the modulus of elasticity. The results are presented in Table 2.

[Comparative Example 5]

A cured epoxy resin was obtained in the same manner as in Example 1 except that the copolymer was replaced with 9.0 g of the polysiloxane-polyalkylene glycol block copolymer obtained in Reference Example 1. The bending modulus of elasticity and the strain at break of the cured epoxy resin obtained were measured, as a result, the bending modulus of elasticity was 1.3 GPa and the strain at break was 4.3%. The average domain diameter of the polysiloxane in the cured epoxy resin was 200000 nm.

The viscosity of the epoxy resin composition at 200°C was 0.12 Pa s, the proportion of increase in the viscosity with respect to the viscosity of the epoxy resin not containing the block copolymer was 3.0 times, and thus, the fluidity was good. The results presented a low modulus of elasticity and excellent fluidity but poor dispersibility in the cured epoxy resin. The results are presented in Table 2.

[Table 2]

| | Block copolymer | Bending modulus of elasticity (GPa) | Average domain diameter of polysiloxane (mn) | Proportion of increase in viscosity (times) |
|---|---|---|---|---|
| Example 1 | Block copolymer obtained in Production Example 2 | 2.1 | 130 | 2.5 |
| Example 2 | Block copolymer obtained in Production Example 3 | 1.8 | 3100 | 2.8 |
| Example 3 | Block copolymer obtained in Production Example 5 | 1.5 | 34700 | 2.0 |
| Example 4 | Block copolymer obtained in Production Example 6 | 1.9 | 430 | 1.8 |
| Example 5 | Block copolymer obtained in Production Example 7 | 2.2 | 880 | 2.0 |
| Example 6 | Block copolymer obtained in Production Examples 4 and 7 | 2.1 | 2010 | 1.8 |
| Example 7 | Block copolymer obtained in Production Example 8 | 1.9 | 2050 | 200000 |
| Example 8 | Block copolymer obtained in Production Example 9 | 2.1 | 180 | 2.3 |
| Example 9 | Block copolymer obtained in Production Example 10 | 2.1 | 1500 | 1.5 |
| Example 10 | Block copolymer obtained in Production Example 11 | 2.0 | 140 | 3.0 |
| Comparative Example 1 | - | 2.9 | - | - |
| Comparative Example 2 | Block copolymer intermediate obtained in Synthesis Example 1 | 2.5 | 53 | 2.8 |
| Comparative Example 3 | Block copolymer intermediate obtained in Synthesis Example 2 | 2.3 | 51 | 2.3 |
| Comparative Example 4 | Block copolymer intermediate obtained in Synthesis Example 3 | 2.4 | 65 | 2.5 |

(continued)

| | Block copolymer | Bending modulus of elasticity (GPa) | Average domain diameter of polysiloxane (mn) | Proportion of increase in viscosity (times) |
|---|---|---|---|---|
| Comparative Example 5 | Block copolymer obtained in Reference Example 1 | 1.3 | 200000 | 3.0 |

## Claims

1. A polysiloxane-polyalkylene glycol block copolymer obtained by
reacting a polysiloxane (A) having a functional group selected from a carboxylic anhydride group, a hydroxyl group, an epoxy group, an amino group, and a thiol group with a polyalkylene glycol (B) having a functional group selected from a carboxylic anhydride group, a hydroxyl group, an amino group, an epoxy group, and a thiol group to obtain a polysiloxane-polyalkylene glycol block copolymer intermediate, and
further reacting a part of the carboxyl groups of the polysiloxane-polyalkylene glycol block copolymer intermediate with a compound reactive with a carboxyl group,
wherein a content of a structure derived from the polysiloxane (A) is 30% by mass or more and 70% by mass or less with respect to 100% by mass of the entire polysiloxane-polyalkylene glycol block copolymer, and
wherein the polysiloxane-polyalkylene glycol block copolymer has a carboxyl group content of 0.1 mmol/g to 0.75 mmol/g and a weight average molecular weight of 5,000 to 500,000.

2. The polysiloxane-polyalkylene glycol block copolymer according to claim 1, wherein the compound reactive with a carboxyl group is at least one selected from ortho esters, oxazolines, epoxies, alcohols, monovalent phenols, alkyl halides, and alkyl carbonates.

3. The polysiloxane-polyalkylene glycol block copolymer according to claim 1 or 2, wherein the product of the number average molecular weight and the carboxyl group content of the polysiloxane-polyalkylene glycol block copolymer is larger than 2.

4. The polysiloxane-polyalkylene glycol block copolymer according to any one of claims 1 to 3, wherein the polysiloxane (A) is represented by Formula (1):

[Chem. 1]

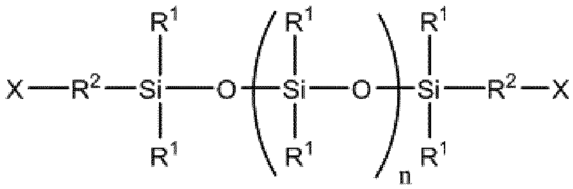

...(1)

wherein Xs denote a functional group selected from a carboxylic anhydride group, a hydroxyl group, an epoxy group, an amino group, and a thiol group, and may be the same as or different from one another;
$R^1$s denote a hydrogen atom, an alkyl group having 1 to 5 carbon atoms, or a phenyl group, and may be the same as or different from one another;
$R^2$s denote a single bond or a divalent aliphatic or aromatic hydrocarbon group having 1 to 10 carbon atoms or a divalent hydrocarbon ether group having 1 to 10 carbon atoms, and may be the same as or different from one another; and
n denotes a number of repeating units from 5 to 100.

5. The polysiloxane-polyalkylene glycol block copolymer according to any one of claims 1 to 4, wherein the polyalkylene glycol (B) is represented by Formula (2):

[Chem. 2]

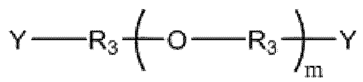

... (2)

wherein Ys denote a functional group selected from a carboxylic anhydride group, a hydroxyl group, an amino group, an epoxy group, and a thiol group, and may be the same as or different from one another;
$R^3$s denote a linear or branched alkyl group having 2 to 10 carbon atoms, and may be the same as or different from one another; and
m denotes a number of repeating units from 3 to 300.

**6.** The polysiloxane-polyalkylene glycol block copolymer according to any one of claims 1 to 5, comprising a structure derived from a copolymerization component (C) having one or more functional groups to react with a functional group of the polysiloxane (A) and/or a functional group of the polyalkylene glycol (B).

**7.** The polysiloxane-polyalkylene glycol block copolymer according to any one of claims 1 to 6, wherein the polyalkylene glycol (B) is polytetramethylene glycol and/or polypropylene glycol.

**8.** A method for producing a polysiloxane-polyalkylene glycol block copolymer, the method comprising the following step (1) followed by the following step (2):

the step (1): reacting a polysiloxane (A) having a functional group selected from a carboxylic anhydride group, a hydroxyl group, an epoxy group, an amino group, and a thiol group with a polyalkylene glycol (B) having a functional group selected from a carboxylic anhydride group, a hydroxyl group, an amino group, an epoxy group, and a thiol group to obtain a polysiloxane-polyalkylene glycol block copolymer intermediate; and
the step (2): reacting a carboxyl group of the polysiloxane-polyalkylene glycol block copolymer intermediate obtained in the step (1) with a compound reactive with a carboxyl group,
wherein the compound reactive with a carboxyl group is at least one selected from ortho esters, oxazolines, epoxies, alcohols, monovalent phenols, alkyl halides, and alkyl carbonates.

**9.** The method for producing a polysiloxane-polyalkylene glycol block copolymer according to claim 8, wherein, in the step (1), the polysiloxane (A), the polyalkylene glycol (B), and a copolymerization component (C) which reacts with a functional group of the polysiloxane (A) and/or a functional group of the polyalkylene glycol (B) are reacted with one another.

**10.** The method for producing a polysiloxane-polyalkylene glycol block copolymer according to claim 8 or 9, wherein, in the step (1), the copolymerization component (C) is a copolymerization component (C') which reacts with both a functional group of the polysiloxane (A) and a functional group of the polyalkylene glycol (B).

**11.** The method for producing a polysiloxane-polyalkylene glycol block copolymer according to any one of claims 8 to 10, wherein the obtained polysiloxane-polyalkylene glycol block copolymer contains:

a structure derived from the polysiloxane (A) in an amount of 30% by mass or more and 70% by mass or less with respect to 100% by mass of the entire polysiloxane-polyalkylene glycol block copolymer; and
a carboxyl group in an amount of 0.1 to 0.75 mmol/g.

**12.** The method for producing a polysiloxane-polyalkylene glycol block copolymer according to any one of claims 8 to 11, wherein, in the step (1), the polysiloxane (A), the polyalkylene glycol (B), and the copolymerization component (C) or (C') are reacted without using a metal catalyst which is a reaction accelerator.

**13.** An epoxy resin composition comprising the polysiloxane-polyalkylene glycol block copolymer according to any one of claims 1 to 7 and an epoxy resin.

**14.** A cured epoxy resin comprising the epoxy resin composition according to claim 13 being cured.

Fig. 1

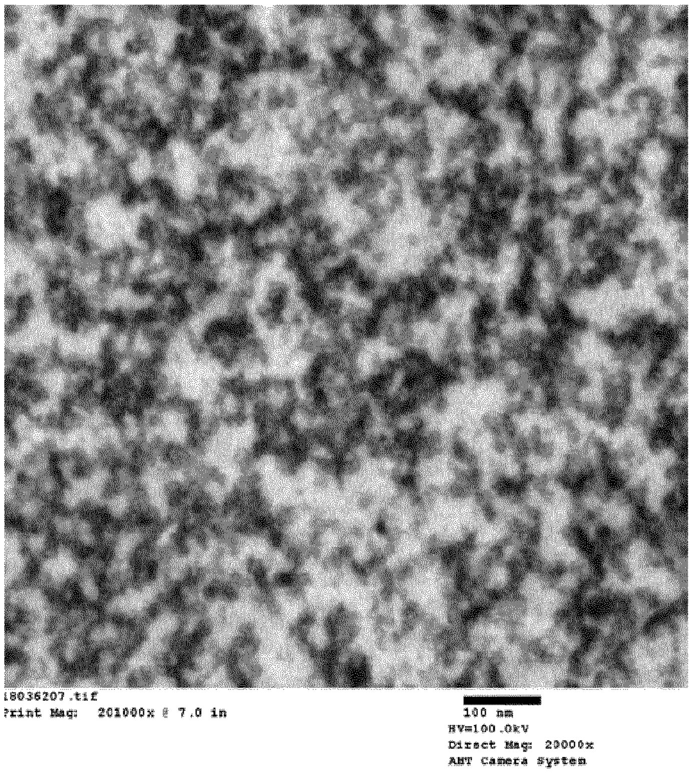
18036207.tif
Print Mag: 201000x @ 7.0 in
100 nm
HV=100.0kV
Direct Mag: 20000x
AMT Camera System

Fig. 2

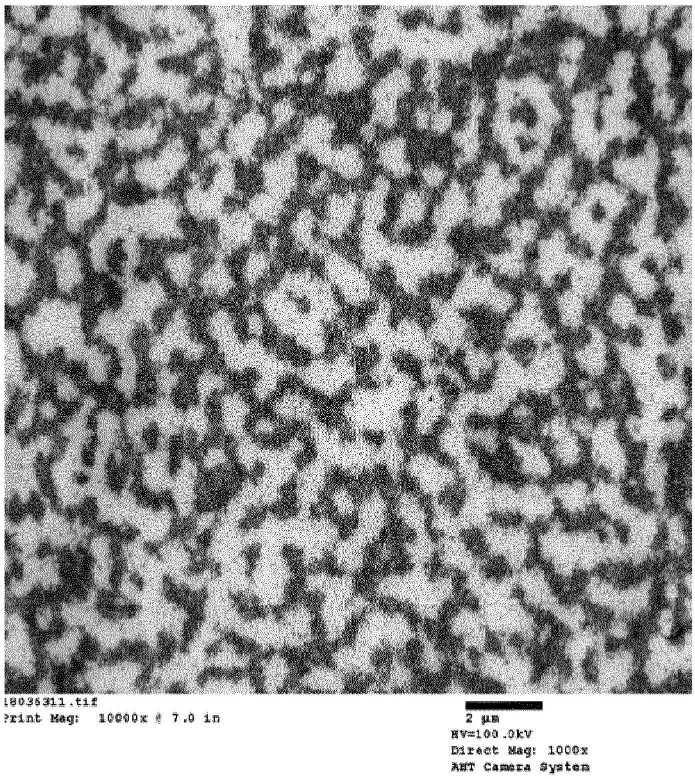
18036311.tif
Print Mag: 10000x @ 7.0 in
2 µm
HV=100.0kV
Direct Mag: 1000x
AMT Camera System

## INTERNATIONAL SEARCH REPORT

International application No. PCT/JP2019/030875

A. CLASSIFICATION OF SUBJECT MATTER
Int.Cl. C08G81/00(2006.01)i, C08L63/00(2006.01)i

According to International Patent Classification (IPC) or to both national classification and IPC

B. FIELDS SEARCHED

Minimum documentation searched (classification system followed by classification symbols)
Int.Cl. C08G81/00, C08L63/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 9-106240 A (TOYO INK MANUFACTURING CO., LTD.) 22 April 1997, claims, paragraphs [0009]-[0016], [0030], examples (Family: none) | 8-10, 12 |
| X | JP 2013-540188 A (NOVARTIS AG.) 31 October 2013, claims, paragraphs [0162]-[0170], examples & US 2012/0088844 A1 & WO 2012/047964 A1, claims, pp. 36, 37, examples & EP 2625217 A1 & CN 103168067 A & KR 10-2013-0126609 A | 8-10, 12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 November 2019 (01.11.2019) | 12 November 2019 (12.11.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/030875

C (Continuation). DOCUMENTS CONSIDERED TO BE RELEVANT

| Category* | Citation of document, with indication, where appropriate, of the relevant passages | Relevant to claim No. |
|---|---|---|
| A | JP 2015-197596 A (JSR CORPORATION) 09 November 2015, entire text (Family: none) | 1-14 |
| A | JP 2012-36348 A (SHIN-ETSU CHEMICAL CO., LTD.) 23 February 2012, entire text & US 2012/0040931 A1, whole document & EP 2418236 A1 & KR 10-2012-0015275 A | 1-14 |
| A | JP 2011-105809 A (MITSUBISHI CHEMICAL CORP.) 02 June 2011, entire text (Family: none) | 1-14 |
| A | JP 11-60822 A (JSR CORPORATION) 05 March 1999, entire text (Family: none) | 1-14 |
| A | JP 8-104831 A (NIPPON PAINT CO., LTD.) 23 April 1996, entire text (Family: none) | 1-14 |
| A | JP 8-73596 A (NIPPON PAINT CO., LTD.) 19 March 1996, entire text (Family: none) | 1-14 |
| P, A | WO 2018/221373 A1 (TORAY INDUSTRIES, INC.) 06 December 2018, entire text & TW 201902999 A | 1-14 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 10182831 A
- JP 4359023 A